# EUROPEAN PATENT SPECIFICATION

(11) **EP 3 783 679 B1**
(45) Date of publication and mention of the grant of the patent: **17.04.2024**
(21) Application number: 19788645.0
(22) Date of filing: 16.04.2019
(51) Int. Cl.: H01B 1/12, H01M 10/052, H02N 2/00, H10N 30/85, H10N 30/857

(54) **SOLID ELECTROLYTE, METHOD FOR PREPARING SAME, AND SELF-GENERATING SECONDARY BATTERY INCLUDING SAME**
FESTELEKTROLYT, VERFAHREN ZU SEINER HERSTELLUNG UND SELBSTGENERIERENDE SEKUNDÄRBATTERIE
ÉLECTROLYTE SOLIDE, SON PROCÉDÉ DE PRÉPARATION ET BATTERIE SECONDAIRE À AUTO-GÉNÉRATION LE COMPRENANT

(30) Priority: 16.04.2018 KR 20180043850; 16.04.2018 KR 20180043847
(43) Date of publication of application: 24.02.2021
(73) Proprietor: INDUSTRY-UNIVERSITY COOPERATION FOUNDATION HANYANG UNIVERSITY ERICA CAMPUS, Sangrok-gu Ansan-si, Gyeonggi-do 15588 (KR)
(72) Inventor: LEE, Jung-Ho, Ansan-si Gyeonggi-do 15588 (KR); SHINDE, Sambhaji Shivaji, Ansan-si Gyeonggi-do 15588 (KR); KIM, Donghyung, Ansan-si Gyeonggi-do 15588 (KR)
(74) Representative: J A Kemp LLP
(86) International application number: PCT/KR2019/004596
(87) International publication number: WO 2019/203549

(56) References cited:
- EP-A1- 3 284 786
- WO-A1-2016/090087
- WO-A1-2017/123026
- WO-A1-2021/075871
- JP-A- 2016 129 428
- KR-A- 20090 004 135
- KR-A- 20120 125 498
- KR-A- 20170 046 698
- US-A1- 2016 312 006

## Description

### [Technical Field]

The present application relates to a solid electrolyte and a method for preparing the same and, more particularly, to a solid electrolyte including a compound in which cations and anions are bonded, and a method for preparing the same. A self-generating secondary battery including the same is also disclosed herein.

### [Background Art]

In general, a secondary battery includes a positive electrode, a negative electrode, and an electrolyte provided between the positive electrode and the negative electrode. The secondary battery is used in portable electronic devices such as smart phones. In the market for portable electronic devices, the electronic devices are being manufactured to have thin and flexible properties. Accordingly, there is a demand for smaller and lighter secondary batteries. Now, however, a liquid-based material, in which salt including ions such as lithium, sodium or the like is mixed in an organic solvent, is mainly used as an electrolyte for the secondary battery. In this case, with the use of the secondary battery, there is a problem in that the organic solvent of the electrolyte is likely to volatilize or leak, and there is also a risk of explosion due to swelling as a temperature rises. Accordingly, there is a growing need for a solid electrolyte with enhanced stability compared to a liquid electrolyte. In this case, the general solid electrolyte has a lower ion conductivity compared to the liquid electrolyte. To compensate for this defect, there has been an ongoing study on the solid electrolyte containing an ionic material.

For example, Korean Unexamined Patent Publication No. 10-2014-0046611 (application no. 10-2012-0111557) provides a composition for an ionic liquid polymer electrolyte, which contains an ionic liquid monomer having a vinyl group and an ionic group, an organic electrolyte, and a cross-linking agent having at least two double bonds at a terminal, in which the ionic group contains cations and anions. Accordingly, disclosed is a method for preparing a composition for an ionic liquid polymer electrolyte capable of solving the problem of electrolyte leakage and providing a lithium secondary battery having excellent flame-retardant properties.
EP 3 284 786 A1 discloses a polyester resin composition and a method of manufacturing the same.
WO 2016/090087 A1 discloses electrically conductive polymer films and complexes containing a conductivity enhancing agent, and electronic devices containing such films and complexes.
US 2016/312006 A1 discloses polymer compositions, films, gels, and foams containing sulfonylimide salts, and electronic devices containing such films, gels, and foams.

### [Disclosure]

### [Technical Problem]

One technical object of the present invention is to provide a solid electrolyte and a method for preparing the same.

Another technical object of the present invention is to provide a solid electrolyte including a compound in which cations and anions are bonded and which has a crystal phase, and a method for preparing the same.

Still another technical object of the present invention is to provide a solid electrolyte having a high ion conductivity, and a method for preparing the same.

Still another technical object of the present invention is to provide an organic piezoelectric material and a method for preparing the same.

Still another technical object of the present invention is to provide an organic piezoelectric material in which cations and anions are bonded and which has a crystal phase, and a method for preparing the same.

Still another technical object of the present invention is to provide an organic piezoelectric material having a high piezoelectric performance, and a method for preparing the same.

The technical objects of the present application are not limited to the above.

### [Technical Solution]

To solve the above technical objects, the present application provides a solid electrolyte.

According to one embodiment, the solid electrolyte includes a compound in which cations having thiophenium and anions having fluorohydrogenate are bonded.

According to one embodiment, the compound may include an alkyl group bonded with a sulfur element of the thiophenium and the alkyl group may include one of a methyl group, an ethyl group, a propyl group or a butyl group.

According to one embodiment, the compound may have an ion conductivity that decreases as a chain of the alkyl group becomes longer.

According to one embodiment, the compound may include a methyl group bonded with a sulfur element of the thiophenium, and may have a first crystal phase in a temperature range of 28 to 90°C and a second crystal phase in a temperature range of 22 to 28°C in a heat flow spectrum according to temperature by differential scanning calorimetry (DSC).

According to one embodiment, the solid electrolyte may further include lithium salt, in which a unit cell of the compound may have an orthorhombic crystal structure, the cation may be provided at a vertex and at a center of a face of the crystal structure, the anion may be provided in a middle of an edge of the crystal structure, and the lithium salt may be arbitrarily provided at interstitial sites of the crystal structure.

According to one embodiment, an ion conductivity of the solid electrolyte may increase as a concentration of the lithium salt increases.

According to one embodiment, a methyl group bonded with a sulfur element of the thiophenium may be provided, and the solid electrolyte may have a crystal phase in a temperature range of 28 to 70°C in a heat flow spectrum according to temperature by differential scanning calorimetry (DSC).

A self-generating secondary battery may include a positive electrode, a negative electrode, and an electrolyte positioned between the positive electrode and the negative electrode, in which the electrolyte may include the compound according to the above-described embodiment and lithium salt.

To solve the above technical objects, the present application provides a solid electrolyte.

According to one embodiment, the solid electrolyte may include a compound in which cations including thiophenium and anions including fluorohydrogenate are bonded.

According to one embodiment, the compound may include an alkyl group bonded with a nitrogen element of the thiazolium and the alkyl group may include one of a methyl group, an ethyl group, a propyl group or a butyl group.

According to one embodiment, the compound may include an ethyl group bonded with a nitrogen element of the thiazolium.

According to one embodiment, the solid electrolyte may further include lithium salt.

To solve the above technical objects, the present application provides a solid electrolyte.

According to one embodiment, the solid electrolyte includes a compound in which cations and anions are bonded, in which the compound has a crystal phase
wherein a molecular weight of the cation is 95 g/mol or more, a molecular weight of the anion is more than 60 g/mol, and a hydrogen ion concentration (pH) of the anion is less than 3, in which an entropy of fusion of the compound is 15-25 J/K mol

According to one embodiment, the cation may include a pentagonal heterocyclic compound, in which the heterocyclic compound may include one element of sulfur, nitrogen, oxygen or phosphorus.

According to one embodiment, if the cation includes thiophenium, the anion may include one of fluorohydrogenate, cyano(nitroso)methanide or tetrazoline.

To solve the above technical objects, the present application provides a method for preparing a solid electrolyte.

According to one embodiment, the method for preparing a solid electrolyte includes providing a mixed solution containing one of thiophenium salt or thiazolium salt, and a fluorohydrogenate precursor, and reacting the mixed solution at a temperature lower than room temperature to prepare a compound in which thiophenium and fluorohydrogenate are bonded, or a compound in which thiazolium and fluorohydrogenate are bonded.

According to one embodiment, the providing of the mixed solution may include preparing the thiophenium salt or the thiazolium salt, in which the preparing of the thiophenium salt or the thiazolium salt may include providing an alkyl group precursor solution, dripping thiophene or thiazoline into the alkyl group precursor solution to prepare a cation source solution, and reacting the cation source solution to prepare the thiophenium salt or the thiazolium salt containing the alkyl group, in which the alkyl group may include one of a methyl group, an ethyl group, a propyl group or a butyl group.

According to one embodiment, the providing of the mixed solution may include the preparing of the fluorohydrogenate precursor, in which the preparing of the fluorohydrogenate precursor may include stirring a solution containing hydrofluoric acid and water to prepare the fluorohydrogenate precursor.

According to one embodiment, the method for preparing a solid electrolyte includes providing lithium fluorohydrogenate, and mixing and heat-treating the compound according to the above-described embodiment and the lithium fluorohydrogenate to prepare a lithium-doped solid electrolyte, in which the providing of the lithium fluorohydrogenate may include adding lithium salt into hydrofluoric acid aqueous solution to prepare a source solution, and reacting the source solution at a temperature lower than room temperature to prepare the lithium fluorohydrogenate.

### [Advantageous Effects]

According to an embodiment of the present invention, the solid electrolyte may include a compound in which cations having thiophenium and anions having fluorohydrogenate are bonded.

In addition, the solid electrolyte may include the compound and lithium salt. In this case, a unit cell of the compound may have an orthorhombic crystal structure, in which the thiophenium may be provided at a vertex and at a center of a face of the crystal structure, and the fluorohydrogenate may be provided in a middle of an edge of the crystal structure. Accordingly, the solid electrolyte may have the lithium salt arbitrarily provided at interstitial sites of the crystal structure.

As described above, the lithium salt may easily move within the crystal structure. Accordingly, the solid electrolyte may have an ion conductivity that becomes higher as a concentration of the lithium salt increases.

In addition, as described above, the solid electrolyte may have a lithium-enriched phase formed. In this case, the lithium-enriched phase may have a relatively low melting point. In other words, the solid electrolyte may have a melting point lower than that of the compound, and thus an entropy of fusion of the solid electrolyte may decrease.

Thus, the solid electrolyte may include the compound in which the cations and the anions are bonded, but may have a crystal phase and a high ion conductivity. Accordingly, the solid electrolyte may be easily provided as an electrolyte for a secondary battery.

The compound, in which the cations including the thiophenium and the anions including the fluorohydrogenate are bonded, may include an organic piezoelectric material. In this case, the organic piezoelectric material may have a crystal structure. If an external force is applied to the organic piezoelectric material, the cations and the anions in a unit cell of the crystal structure may have a displacement, and thus the organic piezoelectric material may have piezoelectric properties.

The organic piezoelectric material may have an entropy of fusion of 15-35 J/K mol. Accordingly, the crystal structure of the organic piezoelectric material may have softness. In addition, the organic piezoelectric material may include a polycrystal having a plurality of microcrystals. Accordingly, the organic piezoelectric material may have piezoelectric properties caused by a spontaneous ionic polarization phenomenon. In this case, the organic piezoelectric material may have a high piezoelectric coefficient of 109 pC/N at room temperature. In addition, the organic piezoelectric material may be prepared at a temperature equal to or lower than room temperature.

Accordingly, the organic piezoelectric material may be prepared at a lower process temperature compared to a conventional inorganic piezoelectric material and through poling at a relatively low voltage. Accordingly, it may be possible to save time and costs required in a process of preparing the organic piezoelectric material. In addition, the organic piezoelectric material may have a higher piezoelectric coefficient compared to a conventional piezoelectric material, and thus can be easily used in various electronic elements such as a self-generating secondary battery, a piezoelectric sensor, a piezoelectric actuator, etc.

In addition, according to an embodiment of the present invention, the solid electrolyte may include a compound in which cations having thiazolium and anions having fluorohydrogenate are bonded. Furthermore, the solid electrolyte may include the compound and lithium salt. The solid electrolyte may have a crystal phase and a high ion conductivity.

### [Description of Drawings]

FIG. 1 is a flowchart for explaining a method for preparing a solid electrolyte according to a first embodiment of the present invention.
FIG. 2 is a view showing a crystal structure of a solid electrolyte according to a first embodiment of the present invention.
FIG. 3 is a schematic view showing a self-generating secondary battery including an organic piezoelectric material according to an embodiment of the present invention.
FIG. 4 shows sectional views of a piezoelectric sensor including an organic piezoelectric material according to an embodiment of the present invention, which represents a driving principle.
FIG. 5 is a block view showing a device including an organic piezoelectric material according to an embodiment of the present invention.
FIG. 6 is a flowchart for explaining a method for preparing a solid electrolyte according to a second embodiment of the present invention.
FIG. 7 is a differential scanning calorimetry (DSC) graph showing a compound according to Experimental Example 1-1 and a solid electrolyte according to Experimental Example 2-3 of the present invention.
FIG. 8 is a graph showing an X-ray diffraction pattern (XRD) of a compound according to Experimental Example 1-1 and a solid electrolyte according to Experimental Example 2-2 of the present invention.
FIG. 9 is a graph showing an ion conductivity according to a temperature of compounds according to Experimental Examples 1-1 to 1-4 and compounds according to Comparative Examples 1-1 to 1-4 of the present invention.
FIG. 10 is a graph showing an ion conductivity according to a temperature of a compound according to Experimental Example 1-1 and solid electrolytes according to Experimental Examples 2-1 to 2-3 of the present invention.
FIG. 11 is a view showing pictures of an electrolyte membrane coated with a solid electrolyte according to an embodiment of the present invention.
FIGS. 12 and 13 are graphs showing results of a cycle test of a secondary battery including a solid electrolyte according to Experimental Example 2-2 of the present invention.
FIG. 14 is a graph showing a capacity retention rate according to charge/discharge rate of a secondary battery including a solid electrolyte according to Experimental Example 2-2 of the present invention.
FIG. 15 is a graph showing an impedance according to a cycle test of a secondary battery including a solid electrolyte according to Experimental Example 2-2 of the present invention.
FIG. 16 is a graph showing a piezoelectric coefficient according to a temperature of an organic piezoelectric material according to an embodiment of the present invention.
FIG. 17 is a graph showing a piezoelectric coefficient according to a frequency of an organic piezoelectric material according to an embodiment of the present invention.
FIG. 18 is a scanning electron microscopy (SEM) image of an organic piezoelectric material according to an embodiment of the present invention.
FIG. 19 is a piezoresponse force microscopy (PFM) image of an organic piezoelectric material according to an embodiment of the present invention.
FIG. 20 is a graph showing a measured ion conductivity of a compound according to Experimental Examples 3-1 to 3-4 of the present invention.
FIG. 21 is a differential scanning calorimetry (DSC) graph of a compound according to Experimental Example 3-1 of the present invention.
FIG. 22 is a graph showing a measured electrochemical window of a compound according to Experimental Example 3-1 of the present invention.

### [Mode for Invention]

Hereinafter, preferred embodiments of the present invention will be described in detail with reference to the accompanying drawings. However, the present invention may be realized in different forms within the scope of protection of the present patent which is determined by the claims in accordance with Article 69 EPC and the Protocol on the Interpretation of Article 69 EPC.

When it is mentioned in the specification that one element is on another element, it means that the first element may be directly formed on the second element or a third element may be interposed between the first element and the second element. Further, in the drawings, the thicknesses of the membrane and areas are exaggerated for efficient description of the technical contents.

Further, in the various embodiments of the present invention, the terms such as first, second, and third are used to describe various elements, but the elements are not limited to the terms. The terms are used only to distinguish one element from another element. Accordingly, an element mentioned as a first element in one embodiment may be mentioned as a second element in another embodiment. The embodiments illustrated here include their complementary embodiments. Further, the term "and/or" in the specification is used to include at least one of the elements enumerated in the specification.

In the specification, the terms of a singular form may include plural forms unless otherwise specified. Further, the terms "including" and "having" are used to designate that the features, the numbers, the steps, the elements, or combinations thereof described in the specification are present, and are not to be understood as excluding the possibility that one or more other features, numbers, steps, elements, or combinations thereof may be present or added.

Further, in the following description of the present invention, a detailed description of known functions and configurations incorporated herein will be omitted when it may make the subject matter of the present invention unnecessarily unclear.

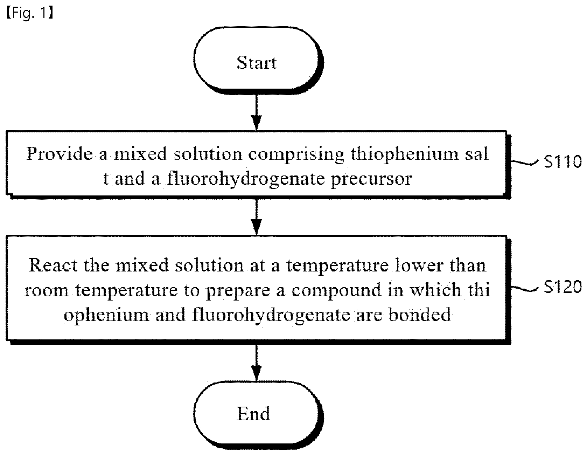

FIG. 1 is a flowchart for explaining a method for preparing a solid electrolyte according to a first embodiment of the present invention.

Referring to FIG. 1, a mixed solution including thiophenium salt and a fluorohydrogenate precursor may be provided (S110).

According to one embodiment, the thiophenium salt may be prepared by reacting an alkyl group precursor solution and thiophene.

In this case, the alkyl group precursor solution may be prepared by adding an alkyl group precursor material into a solvent and stirring at room temperature. For example, the solvent may include acetonitrile. Specifically, for example, the alkyl group precursor material may include one of dichloromethane represented by a following <Chemical Formula 1>, ethyl chloride represented by a following <Chemical Formula 2>, propyl chloride represented by a following <Chemical Formula 3>, or butyl chloride represented by a following <Chemical Formula 4>.

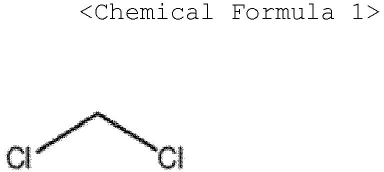

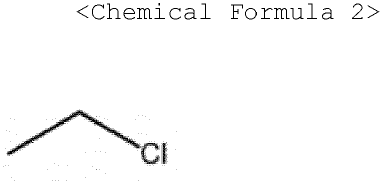

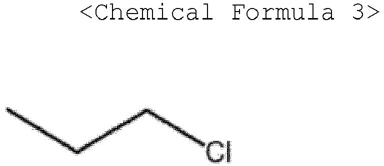

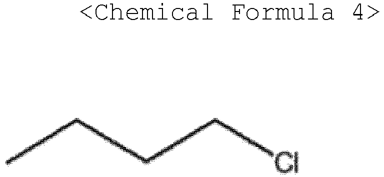

The thiophenium salt may be prepared by dripping the thiophene into the alkyl group precursor solution prepared as described above, and reacting the resulting solution. Unlike the above, if a large amount of the thiophene is added into the alkyl group precursor solution at one time, the reactivity between the thiophene and the alkyl group precursor material may decrease, and thus it may not be easy to prepare the thiophenium salt.

Thus, as described above, if the thiophene is dripped into the alkyl group precursor solution, the reactivity between the thiophene and the alkyl group precursor material may be enhanced. In other words, a yield of the thiophenium salt may be enhanced.

In this case, as a length of a chain of the alkyl group precursor material increases, a time of the reaction may increase. Accordingly, as the length of the chain increases, a temperature of the reaction may increase, and thus the reactivity between the alkyl group precursor material and the thiophene may be enhanced.

Accordingly, the thiophenium salt may include an alkyl group bonded with a sulfur atom of the thiophenium. For example, the thiophenium salt may include thiophenium chloride containing at least one of a methyl group, an ethyl group, a propyl group or a butyl group.

Specifically, for example, if the alkyl group precursor solution includes dichloromethane represented by the above <Chemical Formula 1>, the thiophene may be dripped into the solution containing the dichloromethane, and reacted at room temperature to prepare the thiophenium salt in which a carbon element of the dichloromethane is bonded with a sulfur element of the thiophene. In other words, the thiophenium salt containing a methyl group represented by a following <Chemical Formula 5> may be prepared.

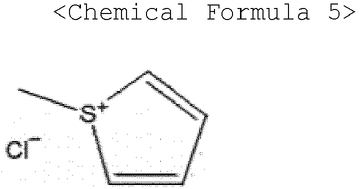

As another example, if the alkyl group precursor solution includes ethyl chloride represented by the above <Chemical Formula 2>, the thiophene may be dripped into the solution containing the ethyl chloride, and reacted at a temperature higher than room temperature to prepare the thiophenium salt in which the ethyl chloride is bonded with a sulfur element at 1-position of the thiophene. In other words, the thiophenium salt containing an ethyl group represented by a following <Chemical Formula 6> may be prepared.

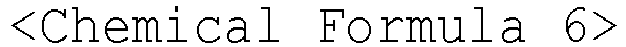

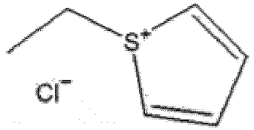

As still another example, if the alkyl group precursor solution includes propyl chloride represented by the above <Chemical Formula 3>, the thiophene may be dripped into the solution containing the propyl chloride, and reacted at a temperature higher than room temperature to prepare the thiophenium salt in which the propyl chloride is bonded with a sulfur element at 1-position of the thiophene. In other words, the thiophenium salt containing a propyl group represented by a following <Chemical Formula 7> may be prepared.

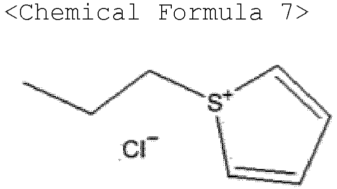

As still another example, if the alkyl group precursor solution includes butyl chloride represented by the above <Chemical Formula 4>, the thiophene may be dripped into the solution containing the butyl chloride, and reacted at a temperature higher than room temperature to prepare the thiophenium salt in which the butyl chloride is bonded with a sulfur element at 1-position of the thiophene. In other words, the thiophenium salt containing a butyl group represented by a following <Chemical Formula 8> may be prepared.

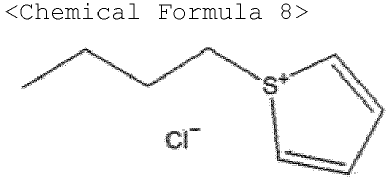

The fluorohydrogenate precursor may be prepared by stirring a solution containing hydrofluoric acid and water. Specifically, for example, the fluorohydrogenate precursor may be prepared by adding and stirring extra water into hydrofluoric acid at a concentration of 1M.

The mixed solution may be reacted to prepare a compound in which thiophenium and fluorohydrogenate are bonded (S120).

Specifically, for example, the mixed solution may be reacted at a temperature of -70°C or less for 24 hours so as to prepare the compound in which the thiophenium and the fluorohydrogenate represented by a following <Chemical Formula 9> are bonded.

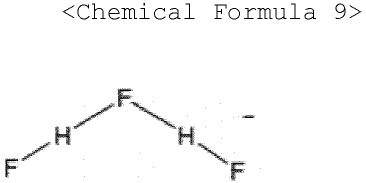

Unlike the above, if the mixed solution is reacted at room temperature, the fluorohydrogenate precursor may be evaporated. Specifically, the fluorohydrogenate precursor may have a boiling point at a temperature equal to or less than room temperature, and thus may be volatilized at room temperature.

Thus, as described above, if the mixed solution is reacted at a temperature of -70°C, the compound may be easily prepared. In addition, as a temperature of the reaction decreases, a loss of the fluorohydrogenate may decrease, and thus a time of the reaction may decrease.

As described above, the compound may include the alkyl group bonded to a sulfur element of the thiophenium. In this case, as a chain of the alkyl group becomes longer, a molecular weight of the thiophenium may increase. Accordingly, an ion conductivity of the compound may decrease. Specifically, for example, if the alkyl group is a methyl group, the compound may have a relatively high ion conductivity, and if the alkyl group is a butyl group, the compound may have a relatively low ion conductivity.

As described above, the compound may be composed of cations having the thiophenium and anions having the fluorohydrogenate and bonded to the cations. In addition, the compound may have a crystal phase.

Specifically, the compound may have a first crystal phase and a second crystal phase depending on a temperature. For example, the first crystal phase may be formed in a temperature range of 28 to 90°C, and the second crystal phase may be formed in a temperature range of 22 to 28°C. In this case, the compound may be subject to a solid-liquid state change at a temperature of 90°C or higher.

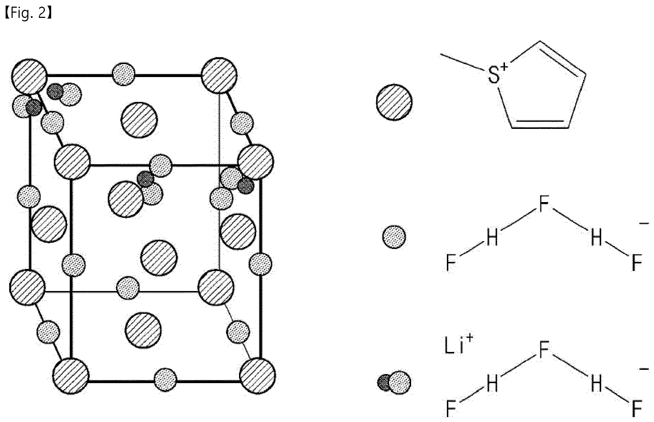

FIG. 2 is a view showing a crystal structure of a solid electrolyte according to an embodiment of the present invention.

Referring to FIG. 2, a solid electrolyte including the compound and lithium salt may be prepared. As shown in FIG. 2, a unit cell of the compound may have an orthorhombic crystal structure, in which the thiophenium may be provided at a vertex and at a center of a face of the crystal structure, and the fluorohydrogenate may be provided in a middle of an edge of the crystal structure. In this case, the solid electrolyte may have the lithium salt arbitrarily provided at interstitial sites of the crystal structure. Specifically, the lithium salt may include lithium fluorohydrogenate. Thus, the solid electrolyte may be prepared by a reaction between the compound and the lithium fluorohydrogenate.

In this case, the lithium fluorohydrogenate may be prepared by adding lithium salt into the fluorohydrogenate precursor and reacting at a temperature lower than room temperature. Referring to FIG. 1, as described above, the lithium fluorohydrogenate may be prepared by using the fluorohydrogenate precursor. Accordingly, the fluorohydrogenate precursor may be prevented from being evaporated through a reaction at a temperature lower than room temperature.

Specifically, for example, if the lithium salt is lithium chloride (LiCl), the lithium fluorohydrogenate may be prepared by adding lithium chloride into the hydrofluoric acid aqueous solution at a concentration of 1M, and reacting at a temperature of -70°C or lower for 24 hours. In this case, the lithium fluorohydrogenate may be prepared through an anion exchange reaction.

The solid electrolyte may be prepared by heating the compound at a temperature higher than room temperature and simultaneously adding the lithium fluorohydrogenate prepared as described above into the compound. For example, the solid electrolyte may be prepared by adding the lithium fluorohydrogenate in an amount of 1 to 10 mol% compared to the compound. As shown in FIG. 2, the lithium salt may be provided at the interstitial sites of the crystal structure of the compound, and thus may easily move within the crystal structure. Accordingly, the solid electrolyte may have an ion conductivity that becomes higher as an amount of the lithium fluorohydrogenate added increases.

In addition, for example, the solid electrolyte may be subject to a solid-liquid state change at a temperature of 70°C or higher, and may have one crystal phase in a temperature range of 28 to 70°C. In other words, the solid electrolyte may have a melting point (a temperature of solid-liquid state change) that becomes lower than that of the compound due to lithium doping, and a temperature of solid-solid state change may vary.

According to an embodiment of the present invention, the compound and the solid electrolyte may show a relatively similar pattern in an X-ray diffraction pattern (XRD). Unlike the compound, however, the solid electrolyte may show a lithium-enriched phase. Accordingly, the compound and the solid electrolyte may have a different crystal orientation.

The solid electrolyte including the compound according to an embodiment of the present invention or the solid electrolyte doped with lithium may be used as an electrolyte for a secondary battery. For example, the secondary battery may include a positive electrode, a negative electrode, and the electrolyte. In this case, the electrolyte may be provided between the positive electrode and the negative electrode.

A method for designing a solid electrolyte according to an embodiment of the present invention will be described.

The solid electrolyte may include a compound in which cations and anions are bonded. In this case, the cations and the anions may be selected to have a maximum ion conductivity in a range satisfying a condition for allowing the compound to have a crystal phase
wherein the condition for allowing the compound to have a crystal phase may include a condition in which a molecular weight of the cation is 95 g/mol or more. In this case, the cation may include a pentagonal heterocyclic compound, in which the heterocyclic compound may have one element of sulfur, nitrogen, oxygen or phosphorus. Specifically, for example, the cation may include one of thiophenium represented by a following <Chemical Formula 10>, thiazolium represented by a following <Chemical Formula 11>, phospholanium represented by a following <Chemical Formula 12>, or oxathiolanium represented by a following <Chemical Formula 13> or <Chemical Formula 14>, or thiazolidinium represented by a following <Chemical Formula 15>.

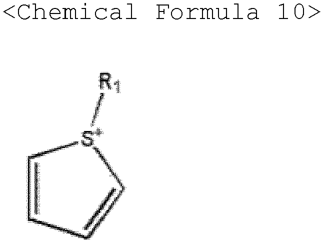

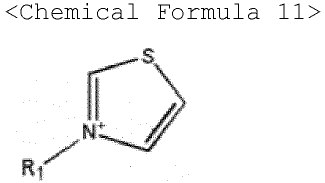

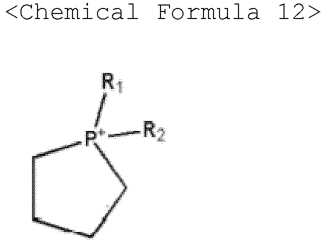

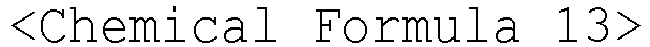

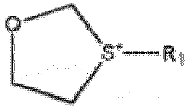

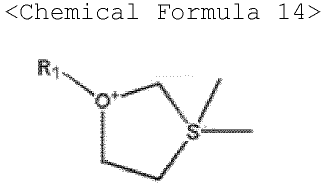

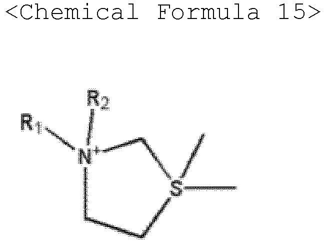

Conditions for allowing the compound to have a crystal phase may include a condition in which a molecular weight of the anion is more than 60 g/mol, and a hydrogen ion concentration (pH) of the anion is less than 3. Specifically, for example, the anion may include one of fluorohydrogenate represented by a following <Chemical Formula 16>, cyano(nitroso)methanide represented by a following <Chemical Formula 17>, or tetrazolidine represented by a following <Chemical Formula 18>.

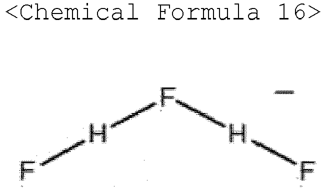

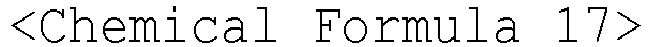

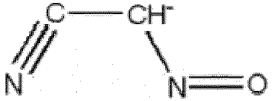

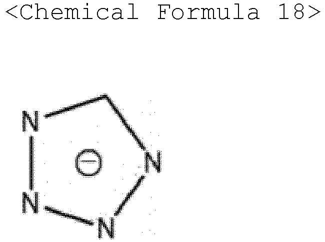

Unlike the above, if the anion has a molecular weight of 60 g/mol or less, the compound may exist in a liquid state. In other words, if the anion has a molecular weight of 60 g/mol or less, it may not be easy to form a solid having a crystal phase. Specifically, for example, if the cation includes one of thiophenium represented by the above <Chemical Formula 10> or thiazolium represented by the above <Chemical Formula 11>, and if the anion includes one of oxohydrogenate represented by a following <Chemical Formula 19> or cyanate represented by a following <Chemical Formula 20>, the compound may exist in an ionic liquid state.

<Chemical Formula 19> O(HO)Oₓ⁻

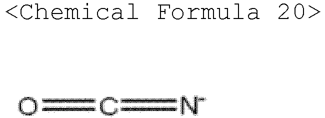

Thus, as described above, if the anion has a molecular weight of more than 60 g/mol, the compound may easily have a crystal phase. Specifically, for example, if the cation includes one of thiophenium represented by the above <Chemical Formula 10> or thiazolium represented by the above <Chemical Formula 11>, and if the anion includes one of fluorohydrogenate represented by the above <Chemical Formula 16>, cyano(nitroso)methanide represented by the above <Chemical Formula 17> or tetrazolidine represented by the above <Chemical Formula 18>, the compound may exist in a solid state of having the crystal phase.

Accordingly, the compound may have a crystal phase, if a molecular weight of the cation is 95 g/mol or more, a molecular weight of the anion is more than 60 g/mol, and a hydrogen ion concentration (pH) of the anion is less than 3. In this case, a condition for allowing the compound to have the crystal phase may be met, and an entropy of fusion of the compound may be 15-25 J/K. Accordingly, the crystal phase may have softness.

Unlike the above, if the entropy of fusion is 10 J/K or less, the compound may have a liquid state. Accordingly, the compound may not easily have a crystal phase. In addition, if the entropy of fusion is more than 35 J/K mol, the compound may have a crystalline solid state and may not have softness.

Thus, as described above, according to an embodiment of the present invention, the entropy of fusion may be 15-25 J/K mol, and thus the compound may easily have a crystal phase and a high ion conductivity at the same time.

According to an embodiment of the present invention, the solid electrolyte including the compound may be used as an electrolyte for a secondary battery. For example, the secondary battery may include a positive electrode, a negative electrode, and the electrolyte. In this case, the electrolyte may be provided between the positive electrode and the negative electrode.

According to a first embodiment of the present invention described above, the compound may include an organic piezoelectric material having piezoelectric properties.

Specifically, in this case, the compound may include a polycrystal having a plurality of microcrystals. In addition, as described above, a crystal structure of the compound may have softness. Thus, the cation and/or the anion may have a displacement within the crystal structure. Accordingly, there may occur an ionic polarization due to a relative displacement of the cation and the anion.

Unlike the compound described above, an inorganic compound including an inorganic matter may be subject to poling under a high voltage condition. Accordingly, the inorganic compound may have piezoelectric properties. In addition, the inorganic compound may be prepared by being heat-treated at a temperature higher than a temperature at which the compound is prepared as described above with reference to FIG. 1.

As described above, however, the compound according to an embodiment of the present invention may be subject to poling at a relatively low voltage to have piezoelectric properties. In addition, as described above with reference to FIG. 1, the compound may be prepared at a temperature equal to or lower than room temperature. Accordingly, the compound may have less time and costs required for a preparation process than those of the inorganic compound.

Specifically, the compound may have a piezoelectric coefficient of 105 to 125 pC/N in a temperature range of room temperature to 110°C. In this case, the compound may have a piezoelectric coefficient of 109 pC/N at room temperature. In addition, the compound may be subject to a phase transition into another crystal structure at 127°C, and thus the compound may not show piezoelectric properties. Thus, the compound may have piezoelectric properties in a temperature range of 127°C or less.

In addition, the compound may have a piezoelectric coefficient of 105 to 125 pC/N in a frequency range of 25 to 250 Hz. In this case, the compound may have a piezoelectric coefficient corresponding to each frequency value. In other words, if a vibration mechanical energy represented by the frequency is applied to the compound, the compound may be converted into different electric signals according to a value of the applied energy. Accordingly, a piezoelectric element including the compound may be easily prepared.

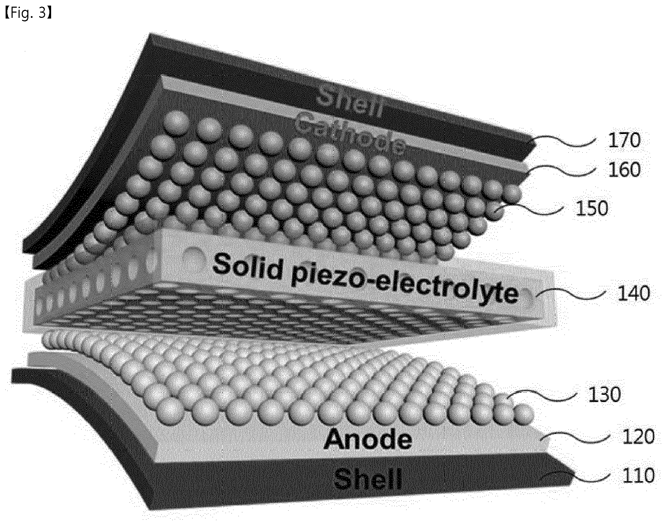

FIG. 3 is a schematic view showing a self-generating secondary battery including an organic piezoelectric material according to an embodiment of the present invention.

Referring to FIG. 3, the self-generating secondary battery may include a positive electrode 160, a negative electrode 120, and an electrolyte 140 disposed between the positive electrode 160 and the negative electrode 120. In this case, the positive electrode 160 and the negative electrode 120 may include a positive electrode active material 150 and a negative electrode active material 130, respectively. As shown in FIG. 3, the positive electrode active material 150 and the negative electrode active material 130 may be provided in the form of particle onto the surfaces of the positive electrode 160 and the negative electrode 120 respectively, or may be mixed and provided in the positive electrode 160 and the negative electrode 120.

The electrolyte 140 may include a piezoelectric body. Accordingly, it may be possible to easily prepare a self-generating secondary battery that converts and stores vibration mechanical energy generated from movement of a human body, wind, wave or the like into electrical energy.

In this case, the electrolyte 140 may include a solid electrolyte containing the compound prepared according to an embodiment of the present invention and lithium salt.

As described above, the compound may have a high piezoelectric constant. In addition, the compound may have a high ion conductivity. Specifically, for example, if the compound includes a compound in which the methyl thiophenium and the fluorohydrogenate are bonded, the ion conductivity of the compound may be 126 S/cm. Accordingly, the solid electrolyte may be easily prepared by mixing lithium salt in the compound.

In addition, the self-generating secondary battery may have a first protective layer 170 on the outside of the positive electrode 160 and a second protective layer 110 on the outside of the negative electrode 120. Accordingly, the positive electrode 160, the negative electrode 120, and the electrolyte 140 may be protected from an external environment. In this case, the first protective layer 170 and the second protective layer 110 may include a polymer resin. Specifically, for example, the first protective layer 170 and the second protective layer 110 may include kapton, polyimide (PI), polyethylene terephthalate (PET), etc.

In contrast, as described above, the solid electrolyte may include the compound and lithium salt. As described with reference to FIG. 2, a unit cell of the compound may have an orthorhombic crystal structure, in which the thiophenium may be provided at a vertex and at a center of a face of the crystal structure, and the fluorohydrogenate may be provided in a middle of an edge of the crystal structure. In this case, as shown in FIG. 2, the solid electrolyte may have the lithium salt arbitrarily provided at interstitial sites of the crystal structure. Specifically, the lithium salt may include lithium fluorohydrogenate. Thus, the solid electrolyte may be prepared by a reaction between the compound and the lithium fluorohydrogenate.

If an external force is applied to the self-generating secondary battery according to an embodiment of the present invention, a piezoelectric field may be generated in the electrolyte 140 including the compound. Specifically, the piezoelectric field may be generated from an upper portion of the electrolyte 140 adjacent to the positive electrode 160 toward a lower portion of the electrolyte 140 adjacent to the negative electrode 120. Lithium ions may move from the positive electrode active material 150 to the negative electrode active material 130 by a piezoelectric field from the positive electrode 160 toward the negative electrode 120. Accordingly, a charge operation of the self-generating secondary battery may be performed by external force.

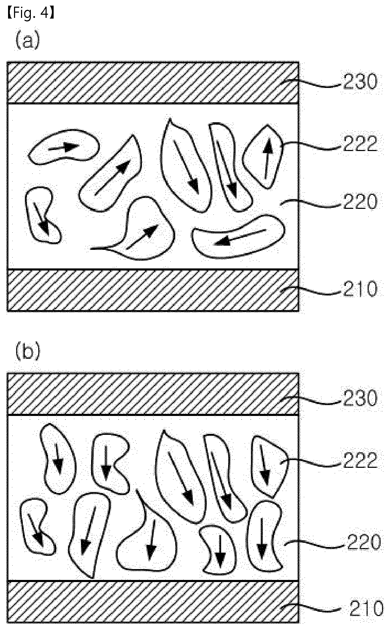

FIG. 4 shows sectional views of a piezoelectric sensor including an organic piezoelectric material according to an embodiment of the present invention, which represents a driving principle. Specifically, (a) of FIG. 4 is a sectional view showing the piezoelectric sensor before an external force is applied, and (b) of FIG. 4 is a sectional view showing the piezoelectric sensor to which an external force is applied.

Referring to FIG. 4, the piezoelectric sensor may include a first electrode 210, a second electrode 230, and a piezoelectric material layer 220 disposed between the first electrode 210 and the second electrode 230.

In this case, the piezoelectric material layer 220 may include a polycrystal. Accordingly, the piezoelectric material layer 220 may include a plurality of microcrystals 222. As shown in (a) of FIG. 4, the plurality of microcrystals 222 may have different polarization directions before an external force is applied to the piezoelectric sensor.

In contrast, as shown in (b) of FIG. 4, if an external force is applied to the piezoelectric sensor, the polarization inside the plurality of microcrystals 222 may be aligned in one direction. Accordingly, a piezoelectric field may be generated between the first electrode 210 and the second electrode 230, so that a potential difference may be formed between the first electrode 210 and the second electrode 230.

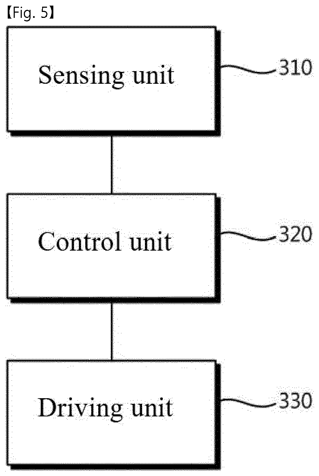

FIG. 5 is a block view showing a device including an organic piezoelectric material according to an embodiment of the present invention.

Referring to FIG. 5, the device may include a sensing unit 310, a driving unit 330, and a control unit 320 that converts an electrical signal obtained from the sensing unit 310 into physical energy to control the driving device 330.

The sensing unit 310 may sense a change in an external environment, convert the change into an electric signal, and provide the electric signal to the control unit 320. In this case, the change in the external environment may be variously selected according to a use of the device.

The control unit 320 may include an actuator containing a piezoelectric material. Accordingly, the piezoelectric material may be subject to a polarization phenomenon due to an electric signal provided from the sensing unit 310, while the electric signal may be converted into physical energy at the same time. In this case, the compound described above with reference to FIGS. 1 to 2 may have piezoelectric properties due to spontaneous ionic polarization. In addition, the compound may have a high piezoelectric coefficient, and thus may be provided as the piezoelectric material of the actuator. For example, the actuator may include a motor, a switch, etc.

The driving unit 330 may include a device that may be driven by the physical energy converted by the control unit 320. For example, the driving unit 330 may include a lighting, a mechanical device, etc.

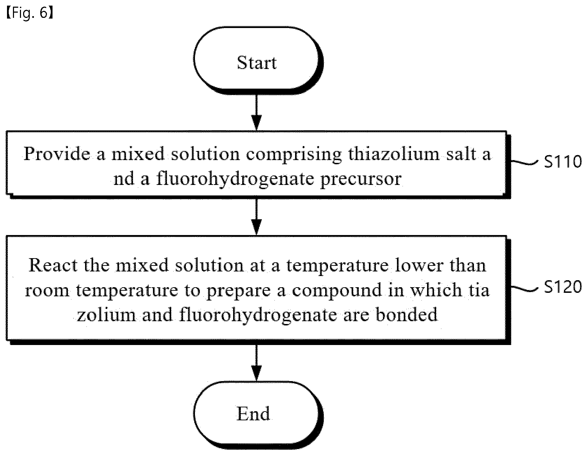

FIG. 6 is a flowchart for explaining a method for preparing a solid electrolyte according to a second embodiment of the present invention.

Referring to FIG. 6, a mixed solution including thiazolium salt and a fluorohydrogenate precursor may be provided (S110).

According to one embodiment, the thiazolium salt may be prepared by reacting an alkyl group precursor solution and thiazoline.

In this case, the alkyl group precursor solution may be prepared by adding an alkyl group precursor material into a solvent and stirring at room temperature. For example, the solvent may include acetonitrile. Specifically, for example, the alkyl group precursor material may include one of dichloromethane represented by a following <Chemical Formula 21>, ethyl chloride represented by a following <Chemical Formula 22>, propyl chloride represented by a following <Chemical Formula 23>, or butyl chloride represented by a following <Chemical Formula 24>.

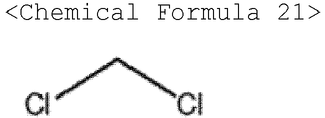

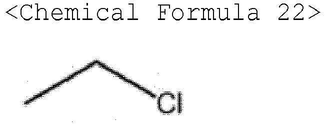

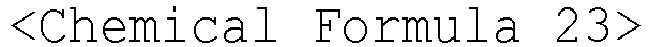

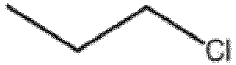

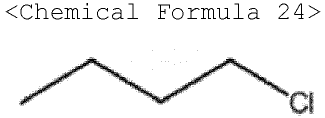

The thiazolium salt may be prepared by dripping the thiazoline into the alkyl group precursor solution prepared as described above, and reacting the resulting solution. Unlike the above, if a large amount of the thiazoline is added into the alkyl group precursor solution at one time, the reactivity between the thiazoline and the alkyl group precursor material may decrease, and thus it may not be easy to prepare the thiazolium salt.

Thus, as described above, if the thiazoline is dripped into the alkyl group precursor solution, the reactivity between the thiazoline and the alkyl group precursor material may be enhanced. In other words, a yield of the thiazolium salt may be enhanced.

In this case, as a length of a chain of the alkyl group precursor material increases, a time of the reaction may increase. Accordingly, as the length of the chain increases, a temperature of the reaction may increase, and thus the reactivity between the alkyl group precursor material and the thiazoline may be enhanced.

Accordingly, the thiazolium salt may include an alkyl group bonded with a nitrogen atom of the thiazolium. For example, the thiazolium salt may include thiazolium chloride containing one of a methyl group, an ethyl group, a propyl group or a butyl group.

Specifically, for example, if the alkyl group precursor solution includes dichloromethane represented by the above <Chemical Formula 1>, the thiazoline may be dripped into the solution containing the dichloromethane, and reacted at room temperature to prepare the thiazolium salt in which a carbon element of the dichloromethane is bonded with a nitrogen element of the thiazoline. In other words, the thiazolium salt containing a methyl group represented by a following <Chemical Formula 25> may be prepared.

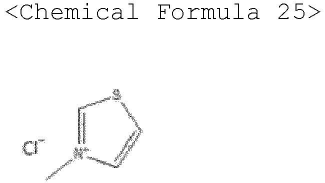

As another example, if the alkyl group precursor solution includes ethyl chloride represented by the above <Chemical Formula 2>, the thiazoline may be dripped into the solution containing the ethyl chloride, and reacted at a temperature higher than room temperature to prepare the thiazolium salt in which the ethyl chloride is bonded with a nitrogen element at 1-position of the thiazoline. In other words, the thiazolium salt containing an ethyl group represented by a following <Chemical Formula 26> may be prepared.

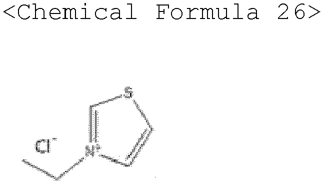

As still another example, if the alkyl group precursor solution includes propyl chloride represented by the above <Chemical Formula 3>, the thiazoline may be dripped into the solution containing the propyl chloride, and reacted at a temperature higher than room temperature to prepare the thiazolium salt in which the propyl chloride is bonded with a nitrogen element at 1-position of the thiazoline. In other words, the thiazolium salt containing a propyl group represented by a following <Chemical Formula 27> may be prepared.

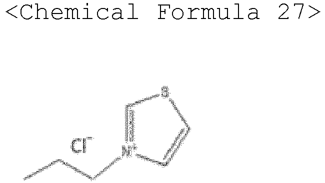

As still another example, if the alkyl group precursor solution includes butyl chloride represented by the above <Chemical Formula 4>, the thiazoline may be dripped into the solution containing the butyl chloride, and reacted at a temperature higher than room temperature to prepare the thiazolium salt in which the butyl chloride is bonded with a nitrogen element at 1-position of the thiazoline. In other words, the thiazolium salt containing a butyl group represented by a following <Chemical Formula 8> may be prepared.

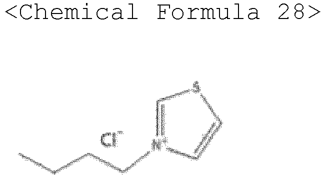

The fluorohydrogenate precursor may be prepared by stirring a solution containing hydrofluoric acid and water. Specifically, for example, the fluorohydrogenate precursor may be prepared by adding and stirring extra water into hydrofluoric acid at a concentration of 1M.

The mixed solution may be reacted to prepare a compound in which thiazolium and fluorohydrogenate are bonded (S120).

Specifically, for example, the mixed solution may be reacted at a temperature of -70°C or less for 24 hours so as to prepare the compound in which the thiazolium and the fluorohydrogenate represented by a following <Chemical Formula 29> are bonded.

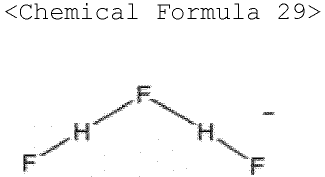

Unlike the above, if the mixed solution is reacted at room temperature, the fluorohydrogenate precursor may be evaporated. Specifically, the fluorohydrogenate precursor may have a boiling point at a temperature equal to or less than room temperature, and thus may be volatilized at room temperature.

Thus, as described above, if the mixed solution is reacted at a temperature of -70°C, the compound may be easily prepared. In addition, as a temperature of the reaction decreases, a loss of the fluorohydrogenate may decrease, and thus a time of the reaction may decrease.

As described above, the compound may be composed of cations having the thiazolium and anions having the fluorohydrogenate and bonded to the cations. In addition, the compound may have a crystal phase.

A solid electrolyte including the compound and lithium salt may be prepared. In this case, the lithium salt may be arbitrarily provided at interstitial sites of the crystal structure of the compound. Specifically, the lithium salt may include lithium fluorohydrogenate. Thus, the solid electrolyte may be prepared by a reaction between the compound and the lithium fluorohydrogenate.

In this case, the lithium fluorohydrogenate may be prepared by adding lithium salt into the fluorohydrogenate precursor and reacting at a temperature lower than room temperature. Referring to FIG. 1, as described above, the lithium fluorohydrogenate may be prepared by using the fluorohydrogenate precursor. Accordingly, the fluorohydrogenate precursor may be prevented from being evaporated through a reaction at a temperature lower than room temperature.

Specifically, for example, if the lithium salt is lithium chloride (LiCl), the lithium fluorohydrogenate may be prepared by adding lithium chloride into the hydrofluoric acid aqueous solution at a concentration of 1M, and reacting at a temperature of -70°C or lower for 24 hours. In this case, the lithium fluorohydrogenate may be prepared through an anion exchange reaction.

The solid electrolyte may be prepared by heating the compound at a temperature higher than room temperature and simultaneously adding the lithium fluorohydrogenate prepared as described above into the compound. For example, the solid electrolyte may be prepared by adding the lithium fluorohydrogenate in an amount of 1 to 10 mol% compared to the compound. The lithium salt may be provided at the interstitial sites of the crystal structure of the compound, and thus may easily move within the crystal structure. Accordingly, the solid electrolyte may have an ion conductivity that becomes higher with the addition of the lithium fluorohydrogenate.

The solid electrolyte including the compound according to an embodiment of the present invention or the solid electrolyte doped with lithium may be used as an electrolyte for a secondary battery. For example, the secondary battery may include a positive electrode, a negative electrode, and the electrolyte. In this case, the electrolyte may be provided between the positive electrode and the negative electrode.

Hereinafter, a method for preparing a solid electrolyte according to the above-described first embodiment of the present invention and the results of evaluating properties will be described.

### Preparing of compound according to Experimental Example 1-1

Dichloromethane represented by the above <Chemical Formula 1> was provided as an alkyl group precursor material.

Acetonitrile was provided into a conical flask, after which the dichloromethane was added and stirred at room temperature for 10 minutes to prepare an alkyl group precursor solution. In this case, the preparation of the alkyl group precursor solution was performed in a glove box without moisture.

Thiophene was dripped into the alkyl group precursor solution while being stirred, after which a uniformly mixed solution was slowly stirred at room temperature for four days so as to prepare thiophenium salt having a methyl group.

A washing process was performed by providing the thiophenium salt and a solvent of ethyl acetate and diethyl ether into a rotary concentrator.

A 1M hydrofluoric acid and extra water was added into a conical flask and stirred for 10 minutes to prepare a fluorohydrogenate precursor.

The thiophenium salt was added into the fluorohydrogenate precursor to prepare a mixed solution. The mixed solution was left alone at a temperature of -70°C for 24 hours, so as to prepare a compound in which the thiophenium salt and the fluorohydrogenate were bonded.

The compound was provided into a glove box under a nitrogen atmosphere and left alone at room temperature for two to three hours, so that volatile gas was removed. After that, a drying process was performed by providing the compound into the rotary concentrator, so as to prepare a compound according to Experimental Example 1-1.

### Preparing of compound according to Experimental Example 1-2

A compound was prepared by the same method as described above in Experimental Example 1-1. However, instead of the dichloromethane, ethyl chloride represented by the above <Chemical Formula 2> was provided as the alkyl group precursor material. In addition, in the preparing of thiophenium, a reaction was performed at a temperature of 60 to 80°C for two to three days instead of the reaction at room temperature for four days, so as to prepare a compound according to Experimental Example 1-2.

### Preparing of compound according to Experimental Example 1-3

A compound was prepared by the same method as described above in Experimental Example 1-1. However, instead of the dichloromethane, propyl chloride represented by the above <Chemical Formula 3> was provided as the alkyl group precursor material. In addition, in the preparing of thiophenium, a reaction was performed at a temperature of 60 to 80°C for two to three days instead of the reaction at room temperature for four days, so as to prepare a compound according to Experimental Example 1-3.

### Preparing of compound according to Experimental Example 1-4

A compound was prepared by the same method as described above in Experimental Example 1-1. However, instead of the dichloromethane, butyl chloride represented by the above <Chemical Formula 4> was provided as the alkyl group precursor material. In addition, in the preparing of thiophenium, a reaction was performed at a temperature of 60 to 80°C for two to three days instead of the reaction at room temperature for four days, so as to prepare a compound according to Experimental Example 1-4.

### Preparing of solid electrolyte according to Experimental Example 2-1

A 1M hydrofluoric acid aqueous solution and lithium chloride (LiCl) were added into a container and left alone at a temperature of -70°C for 24 hours, so as to prepare lithium fluorohydrogenate.

A compound having a methyl group according to Experimental Example 1-1 described above was heated to 60°C and the lithium fluorohydrogenate was added in an amount of 1 mol% at the same time and reacted for two hours, so as to prepare a solid electrolyte according to Experimental Example 2-1.

### Preparing of solid electrolyte according to Experimental Example 2-2

A solid electrolyte was prepared by the same method as described above in Experimental Example 2-1. However, the lithium fluorohydrogenate was added in an amount of 5 mol% instead of 1 mol%, so as to prepare a solid electrolyte according to Experimental Example 2-2.

### Preparing of solid electrolyte according to Experimental Example 2-3

A solid electrolyte was prepared by the same method as described above in Experimental Example 2-1. However, the lithium fluorohydrogenate was added in an amount of 10 mol% instead of 1 mol%, so as to prepare a solid electrolyte according to Experimental Example 2-3.

### Preparing of compound according to Comparative Example 1-1

As for a cation, thiazolium represented above was provided. In this case, the R₁ represents an ethyl group.

As for an anion, fluorohydrogenate prepared according to Experimental Example 1-1 described above was used to prepare a compound according to Comparative Example 1-1.

### Preparing of compound according to Comparative Example 1-2

As for a cation, phospholanium represented by the above <Chemical Formula 12> was provided.

In this case, the R₁ and R₂ represent an ethyl group and a butyl group, respectively.

As for an anion, fluorohydrogenate prepared according to Experimental Example 1-1 described above was used to prepare a compound according to Comparative Example 1-2.

### Preparing of compound according to Comparative Example 1-3

As for a cation, pyrrolidinium represented by a following <Chemical Formula 30> was provided.

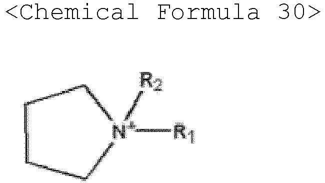

In this case, the R₁ and R₂ represent an ethyl group and a butyl group, respectively.

As for an anion, fluorohydrogenate prepared according to Experimental Example 1-1 described above was used to prepare a compound according to Comparative Example 1-3.

### Preparing of compound according to Comparative Example 1-4

As for a cation, imidazolium represented by the above <Chemical Formula 31> was provided. In this case, the R₁ and R₂ represent a methyl group and an ethyl group, respectively.

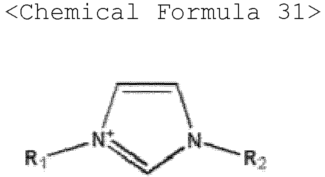

As for an anion, fluorohydrogenate prepared according to Experimental Example 1-1 described above was used to prepare a compound according to Comparative Example 1-4.

### Preparing of compound according to Comparative Example 1-5

As for a cation, a methyl group and an ethyl group were bonded to nitrogen of thiazolidinium represented by the above <Chemical Formula 15>, and two methyl groups were bonded to sulfur of thiazolidinium.

As for an anion, fluorohydrogenate prepared according to Experimental Example 1-1 described above was used to prepare a compound according to Comparative Example 1-5.

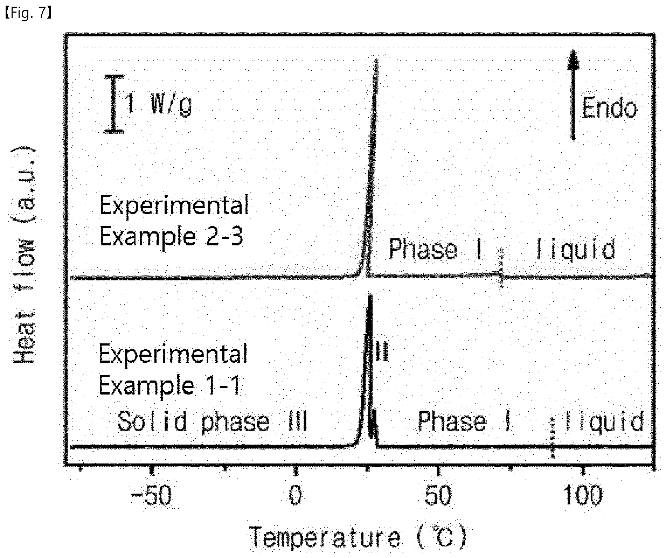

FIG. 7 is a differential scanning calorimetry (DSC) graph showing a compound according to Experimental Example 1-1 and a solid electrolyte according to Experimental Example 2-3 of the present invention.

Referring to FIG. 7, a solid-liquid or solid-solid state change according to temperature may be observed in the compound according to Experimental Example 1-1 and the solid electrolyte according to Experimental Example 2-3.

As shown in FIG. 7, the solid-liquid state change was observed in the compound at 90°C. In this case, an entropy of fusion of the compound was calculated to be 32 J/K mol. In contrast, the solid-liquid state change was observed in the solid electrolyte at 70°C. In this case, an entropy of fusion of the solid electrolyte was calculated to be 24 J/K mol.

In addition, the solid-solid state change was observed twice in the compound. Accordingly, it was confirmed that the compound has a first crystal phase in a temperature range of 28 to 90°C and a second crystal phase in a temperature range of 22 to 28°C. In contrast, it was confirmed that the solid-solid state change is observed once in the solid electrolyte, so as to have one crystal phase in a temperature range of 22 to 70°C.

Thus, the compound further includes the lithium salt, and a melting point (a temperature of solid-liquid state change) may decrease. Accordingly, it can be confirmed that the entropy of fusion required for the state change decreases. In addition, it can be confirmed that the compound further includes the lithium salt and a temperature of the solid-solid state change varies.

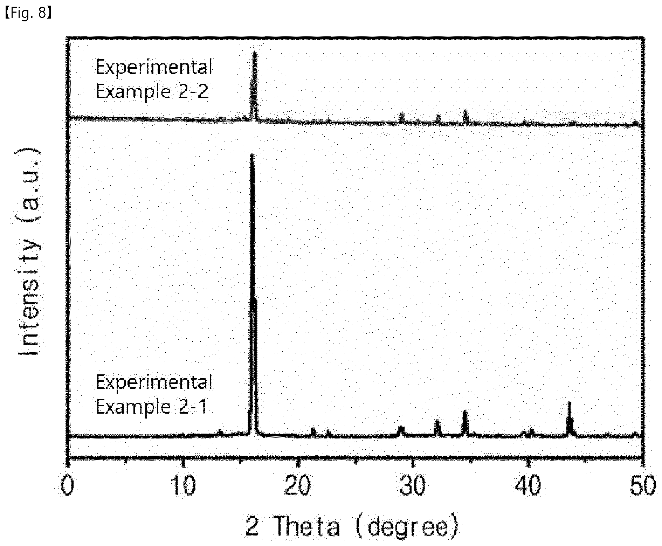

FIG. 8 is a graph showing an X-ray diffraction pattern (XRD) of a compound according to Experimental Example 1-1 and a solid electrolyte according to Experimental Example 2-2 of the present invention.

Referring to FIG. 8, a change in crystal structure may be observed in a solid electrolyte according to Experimental Example 2-2 compared to a compound according to Experimental Example 1-1.

As shown in FIG. 8, it was confirmed that the compound and the solid electrolyte have the same position of main peaks. In contrast, it was observed that the intensities of the peaks are different from each other. Accordingly, it can be understood that the solid electrolyte further includes a lithium-enriched phase and a crystal orientation is changed in the solid electrolyte compared to the compound.

As described above, the solid electrolyte may further include a phase having a different composition compared to the compound. In this case, the phase having a different composition is liquefied at a relatively low temperature, and thus the solid electrolyte may have a lower melting point compared to the compound, as described above in FIG. 2.

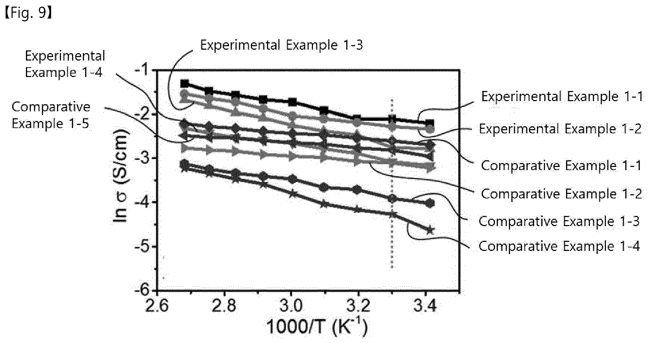

FIG. 9 is a graph showing an ion conductivity according to a temperature of compounds according to Experimental Examples 1-1 to 1-4 and compounds according to Comparative Examples 1-1 to 1-5 of the present invention.

Referring to FIG. 9, compounds according to Experimental Examples 1-1 to 1-4 and compounds according to Comparative Examples 1-1 and 1-4 include the same anion, in which the anion may be fluorohydrogenate. Accordingly, an ion conductivity according to a change of the cation may be compared.

As shown in FIG. 9, the compounds according to the experimental examples of the present invention showed an ion conductivity high than that of the compounds according to the comparative examples. In addition, the compounds according to the experimental examples of the present invention showed a higher ion conductivity as a length of the alkyl group chain decreases. Specifically, the compound showed an ion conductivity of 46 to 126 mS/cm at room temperature, and the compound having a methyl group showed the highest ion conductivity of 126 mS/cm.

**[Table 1]**

| | Alkyl group | Ion conductivity (mS/cm) |
|---|---|---|
| Experimental Example 1-1 | Methyl group | 126 |
| Experimental Example 1-2 | Ethyl group | 103 |
| Experimental Example 1-3 | Propyl group | 68 |
| Experimental Example 1-4 | Butyl group | 46 |

In addition, in addition to the compounds according to Comparative Examples 1-1 to 1-5, structures and ion conductivities of other compounds having a high ion conductivity at room temperature are shown in a following <Table 2>.

**[Table 2]**

| Cation | R₁ or R₁/R₂ | Ion conductivity (mS/cm) |
|---|---|---|
| Thiazolium | Methyl group | 45 |
| | Ethyl group | 74 |
| | Propyl group | 18.9 |
| | Butyl group | 6.8 |
| Phospholanium | Methyl group/Ethyl group | 2 |
| | Methyl group/Propyl group | 35 |
| | Methyl group/Butyl group | 16 |
| | Ethyl group/Butyl group | 45 |
| | Methyl group/Methyl group | 24 |
| Thiazolidinium | Methyl group/Ethyl group (N) + Two methyl groups (S) | 60 |
| | Methyl group/Propyl group (N) + Two methyl groups (S) | 19.6 |
| | Methyl group/Butyl group (N) + Two methyl groups (S) | 28.7 |
| | Ethyl group/Butyl group (N) + Two methyl groups (S) | 5.8 |
| Imidazolium | Methyl group/Ethyl group | 14 |
| | Methyl group/Propyl group | 6.5 |
| | Methyl group/Butyl group | 8.9 |
| | Ethyl group/Butyl group | 2.5 |
| Pyrrolidinium | Methyl group/Ethyl group | 7 |
| | Methyl group/Propyl group | 65.3 |
| | Methyl group/Butyl group | 14.5 |
| | Ethyl group/Butyl group | 20 |
| | Methyl/Methyl | 0.9 |

As can be understood from <Table 2>, the compound of <Table 2> may include one of thiazolium represented by the above <Chemical Formula 11>, phospholanium represented by the above <Chemical Formula 12>, and thiazolidinium represented by the above <Chemical Formula 15> (a change in an alkyl group bonded to nitrogen while two methyl groups are fixedly bonded to sulfur), imidazolium represented by the above <Chemical Formula 31>, or pyrrolidinium represented by the above <Chemical Formula 30> as a cation. As described above with reference to FIG. 9 and <Table 1>, it can be confirmed that the compound according to an experimental example of the present invention has an ion conductivity higher than that of the compound of <Table 2>.

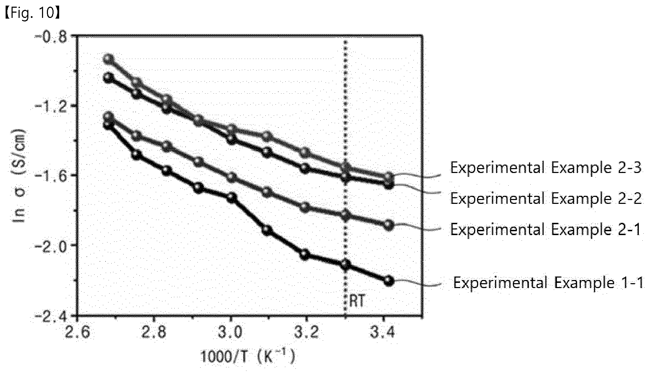

FIG. 10 is a graph showing an ion conductivity according to a temperature of a compound according to Experimental Example 1-1 and solid electrolytes according to Experimental Examples 2-1 to 2-3 of the present invention.

Referring to FIG. 10, an ion conductivity according to a concentration of the compound according to Experimental Example 1-1 having the highest ion conductivity described above with reference to FIG. 5 and the lithium salt added to the compound was confirmed. The solid electrolyte further contained the lithium fluorohydrogenate in an amount of 1 to 10 mol% compared to the compound. As described above in FIG. 2, the solid electrolyte may have the lithium salt arbitrarily provided at interstitial sites of the crystal structure of the compound. Thus, the lithium salt may easily move within the crystal structure, and thus it was observed that the solid electrolyte has a higher ion conductivity as an amount of lithium fluorohydrogenate added increases.

In this case, the lithium salt may move to interstitial sites where the lithium salt is not provided, and may show an ion conductivity. Thus, with an increase in the interstitial sites where the lithium salt is provided, the lithium salt may not relatively easily move. Accordingly, it was observed that the ion conductivity substantially reaches saturation, if an amount of the lithium fluorohydrogenate added is 5 mol% or more.

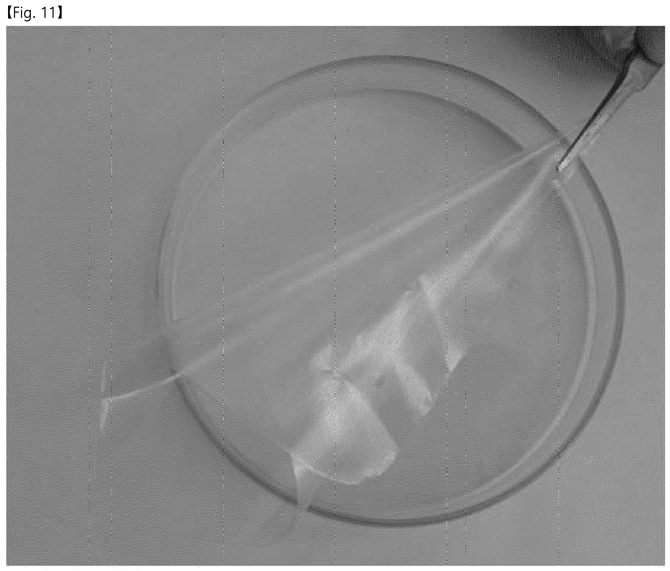

FIG. 11 is a view showing pictures of an electrolyte membrane coated with a solid electrolyte according to an embodiment of the present invention.

Referring to FIG. 11, a picture was taken of a solid electrolyte membrane in the form of a film in which a solid electrolyte according to an embodiment of the present invention is coated on a polytetrafluoroethylene (PTFE) resin. In this case, it was confirmed that the solid electrolyte membrane maintains the softness and transparency of the resin.

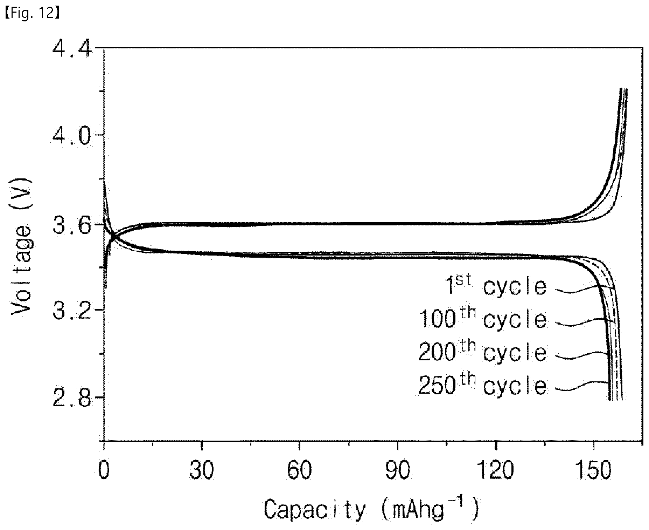

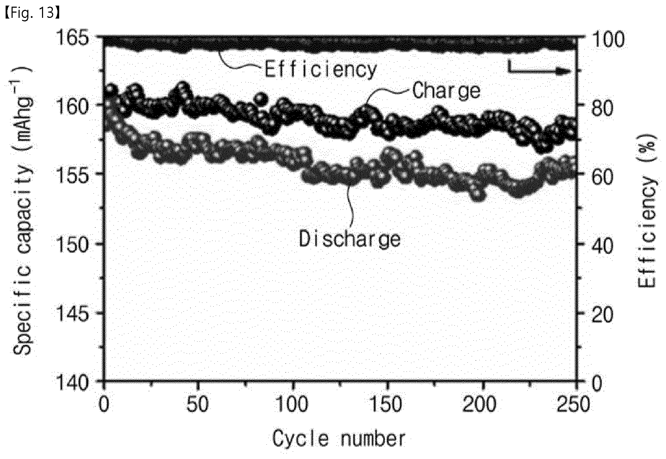

FIGS. 12 and 13 are graphs showing results of a cycle test of a secondary battery including a solid electrolyte according to Experimental Example 2-2 of the present invention.

Referring to FIGS. 12 and 13, the charge/discharge properties of a secondary battery including the solid electrolyte in which the ion conductivity substantially reaches saturation as described above with reference to FIG. 11 was confirmed. In other words, the secondary battery included the solid electrolyte according to Experimental Example 2-2 of the present invention. In addition, the secondary battery included LiFePO₄ as a positive electrode, lithium metal as a negative electrode, and polyethylene (PE) as a separator between the positive electrode and the negative electrode.

In this case, the secondary battery was subject to a cycle test at a rate of 1C. In a first cycle, the secondary battery showed a coulombic efficiency of 99.5% and a capacity of 158.6 mAh/g. In a 250th cycle, the secondary battery showed a coulomb efficiency of 98% and a capacity of 155.5 mAh/g. Thus, it may be possible to provide the secondary battery that shows a coulomb efficiency close to 99% even in the 250th cycle and has excellent cycle stability.

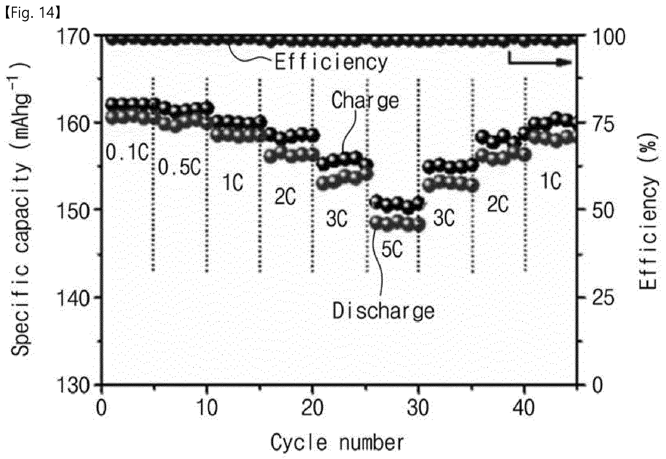

FIG. 14 is a graph showing a capacity retention rate according to charge/discharge rate of a secondary battery including a solid electrolyte according to Experimental Example 2-2 of the present invention.

Referring to FIG. 14, a rate of the secondary battery manufactured with reference to FIGS. 12 and 13 was changed at every certain cycle, and thus a degree to which a capacity of the secondary battery is maintained was confirmed. In this case, a charge/discharge rate of the secondary battery increased to 0.1 to 5C, and again decreased to 1C. Accordingly, if the charge/discharge rate was 0.1, 0.5, 1, 2, 3 and 5C, a discharge capacity was measured to be 161.0, 160.5, 158.6, 156.4, 153.8 and 148.9 mAh/g, respectively. Thus, it was confirmed that the secondary battery maintains a constant capacity regardless of a change in rate.

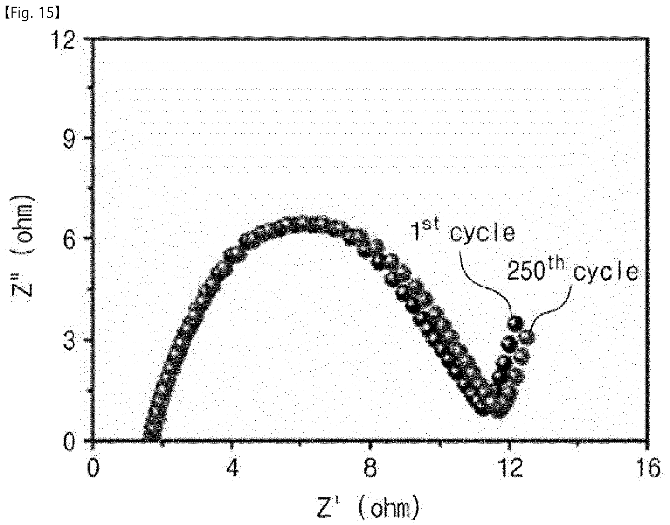

FIG. 15 is a graph showing an impedance according to a cycle test of a secondary battery including a solid electrolyte according to Experimental Example 2-2 of the present invention.

Referring to FIG. 15, in the secondary battery manufactured with reference to FIGS. 12 and 13, an interphase impedance (R_{SEI}) and an electron transfer impedance (R_{CT}) in the first cycle and the 250th cycle was measured. The interphase impedance and the electron transfer impedance in the first cycle were calculated to be 1.65 and 11.22 Ω, respectively. In addition, the interphase impedance and the electron transfer impedance in the 250th cycle were calculated to be 1.75 and 11.65 Ω, respectively. In the secondary battery, as a number of cycles increases, elements included in the components of the secondary battery may be subject to movement and diffusion. Accordingly, resistance in the secondary battery may increase, and charge/discharge properties of the secondary battery may decrease. However, it was observed that the secondary battery including the solid electrolyte according to an exemplary embodiment of the present invention shows a relatively low increase in the impedance in the 250th cycle. Thus, it can be confirmed that the secondary battery including the solid electrolyte according to an embodiment of the present invention has excellent chemical stability.

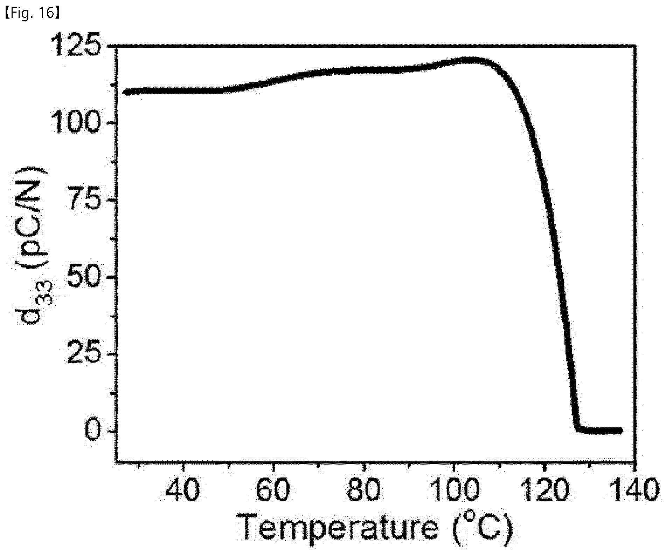

FIG. 16 is a graph showing a piezoelectric coefficient according to a temperature of an organic piezoelectric material according to an embodiment of the present invention.

Referring to FIG. 16, it can be confirmed that an organic piezoelectric material according to an experimental example of the present invention shows piezoelectric properties in a range before a temperature of phase transition. In this case, among the piezoelectric materials mainly used in the related art, barium titanium oxide (BaTiO₃), quartz, etc. are used as an inorganic matter, and PVDF, etc. is used as an organic matter, and the piezoelectric coefficients of the conventional piezoelectric materials are shown in a following <Table 3>.

**[Table 3]**

| Piezoelectric material | Types of piezoelectric material | Piezoelectric coefficient (pC/N) |
|---|---|---|
| [001] Direction, BaTiO₃ | Inorganic matter | 90 |
| PVDF | Organic matter | 23 |
| Quartz | Inorganic matter | 5 |

As can be understood from <Table 3> and FIG. 16, the organic piezoelectric material may have a piezoelectric coefficient of 109 pC/N at room temperature. Accordingly, it can be understood that the organic piezoelectric material has a higher piezoelectric coefficient than that of a conventional piezoelectric material.

As shown in FIG. 16, it was confirmed that the organic piezoelectric material has a piezoelectric coefficient of 105 to 125 pC/N in a temperature range of room temperature to 110°C. In addition, it was confirmed that the organic piezoelectric material is subject to a phase transition into a different crystal structure at 127°C, and thus the organic piezoelectric material does not have piezoelectric properties.

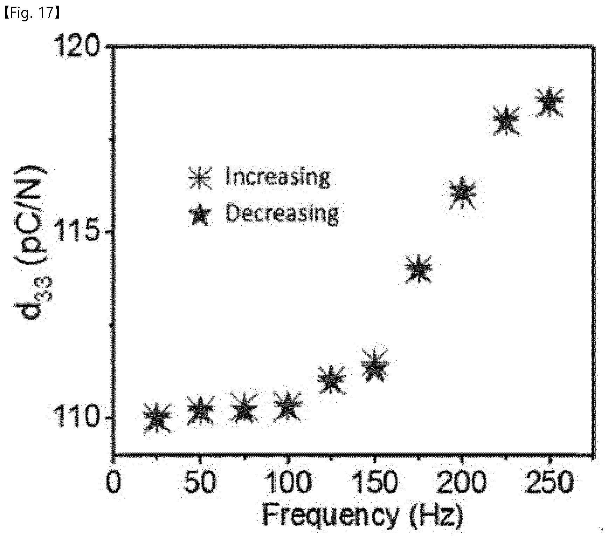

FIG. 17 is a graph showing a piezoelectric coefficient according to a frequency of an organic piezoelectric material according to an embodiment of the present invention.

Referring to FIG. 17, it was confirmed that the organic piezoelectric material has a piezoelectric coefficient of 105 to 125 pC/N in a frequency range of 25 to 250 Hz. In addition, a piezoelectric coefficient of the organic piezoelectric material was confirmed by increasing or decreasing a value of the frequency. In this case, it was confirmed that the compound has a piezoelectric coefficient corresponding to each frequency value.

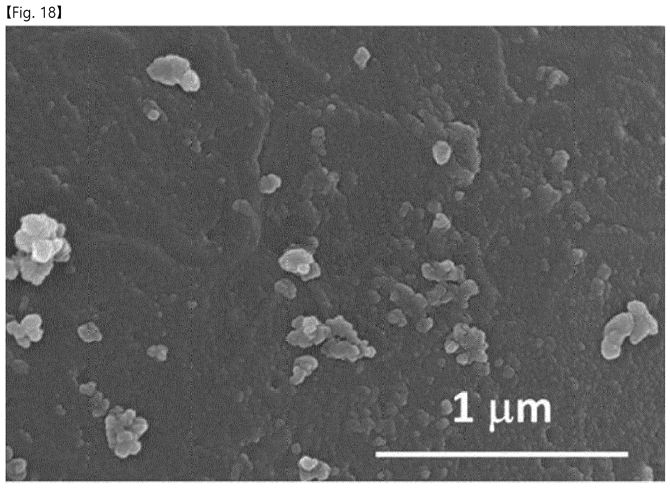

FIG. 18 is a scanning electron microscopy (SEM) image of an organic piezoelectric material according to an embodiment of the present invention.

Referring to FIG. 18, a surface image of an organic piezoelectric material according to an experimental example of the present invention was photographed by a scanning electron microscope. Accordingly, it can be understood that the organic piezoelectric material may have a solid state at room temperature.

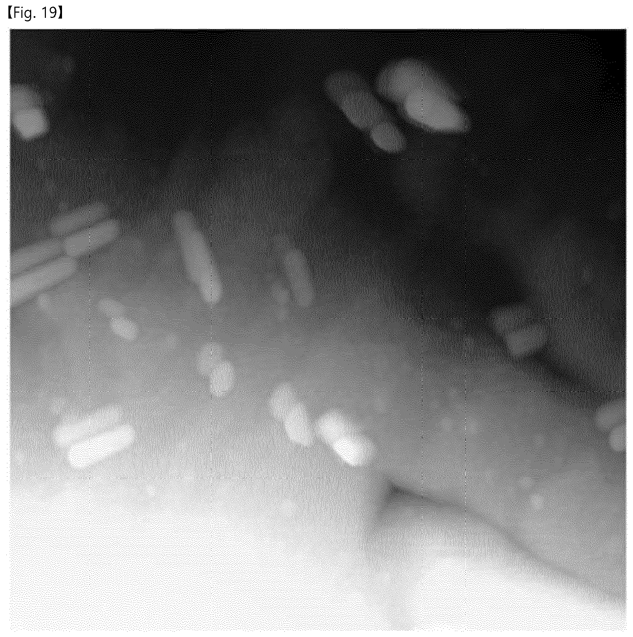

FIG. 19 is a piezoresponse force microscopy (PFM) image of an organic piezoelectric material according to an embodiment of the present invention.

Referring to FIG. 19, the piezoresponse force microscope applies an electric field to a sample from a tip of the piezoresponse force microscope, and thus a physical change such as expansion or compression may occur in the sample. A position of the tip of the piezoresponse force microscope may be changed according to the physical change, so as to generate a piezoresponse force microscopy image.

As shown in FIG. 19, a surface image of an organic piezoelectric material according to Experimental Example 1-1 of the present invention was confirmed through a piezoresponse force microscope.

Hereinafter, a method for preparing a solid electrolyte according to a second embodiment of the present invention described above and the results of evaluating properties.

### Preparing of compound according to Experimental Example 3-1

Dichloromethane represented by the above <Chemical Formula 21> was provided as an alkyl group precursor material.

Acetonitrile was provided into a conical flask, after which the dichloromethane was added and stirred at room temperature for 10 minutes to prepare an alkyl group precursor solution. In this case, the preparation of the alkyl group precursor solution was performed in a glove box without moisture.

Thiazoline was dripped into the alkyl group precursor solution while being stirred, after which a uniformly mixed solution was slowly stirred at room temperature for four days so as to prepare thiazolium salt having a methyl group.

A washing process was performed by providing the thiazolium salt and a solvent of ethyl acetate and diethyl ether into a rotary concentrator.

A 1M hydrofluoric acid and extra water was added into a conical flask and stirred for 10 minutes to prepare a fluorohydrogenate precursor.

The thiazolium salt was added into the fluorohydrogenate precursor to prepare a mixed solution. The mixed solution was left alone at a temperature of -70°C for 24 hours, so as to prepare a compound in which the thiazolium salt and the fluorohydrogenate were bonded.

The compound was provided into a glove box under a nitrogen atmosphere and left alone at room temperature for two to three hours, so that volatile gas was removed. After that, a drying process was performed by providing the compound into the rotary concentrator, so as to prepare a compound according to Experimental Example 3-1.

### Preparing of compound according to Experimental Example 3-2

A compound was prepared by the same method as described above in Experimental Example 3-1. However, instead of the dichloromethane, ethyl chloride represented by the above <Chemical Formula 22> was provided as the alkyl group precursor material. In addition, in the preparing of thiazolium salt, a reaction was performed at a temperature of 60 to 80°C for two to three days instead of the reaction at room temperature for four days, so as to prepare a compound according to Experimental Example 3-2.

### Preparing of compound according to Experimental Example 3-3

A compound was prepared by the same method as described above in Experimental Example 3-1. However, instead of the dichloromethane, propyl chloride represented by the above <Chemical Formula 23> was provided as the alkyl group precursor material. In addition, in the preparing of thiazolium salt, a reaction was performed at a temperature of 60 to 80°C for two to three days instead of the reaction at room temperature for four days, so as to prepare a compound according to Experimental Example 3-3.

### Preparing of compound according to Experimental Example 3-4

A compound was prepared by the same method as described above in Experimental Example 3-1. However, instead of the dichloromethane, butyl chloride represented by the above <Chemical Formula 24> was provided as the alkyl group precursor material. In addition, in the preparing of thiazolium salt, a reaction was performed at a temperature of 60 to 80°C for two to three days instead of the reaction at room temperature for four days, so as to prepare a compound according to Experimental Example 3-4.

### Preparing of compound according to Comparative Example 2-1

As for a cation, phospholanium represented by the above <Chemical Formula 12> was provided. In this case, the R₁ and R₂ represent an alkyl group in a following [Table 4], respectively.

As for an anion, fluorohydrogenate prepared according to Experimental Example 3-1 described above was used to prepare a compound according to Comparative Example 2-1.

### Preparing of compound according to Comparative Example 2-2

As for a cation, imidazolium represented by the above <Chemical Formula 31> was provided.

In this case, the R₁ and R₂ represent an alkyl group in a following [Table 4], respectively.

As for an anion, fluorohydrogenate prepared according to Experimental Example 3-1 described above was used to prepare a compound according to Comparative Example 2-2.

### Preparing of compound according to Comparative Example 2-3

As for a cation, pyrrolidinium represented by the above <Chemical Formula 30> was provided.

In this case, the R₁ and R₂ represent an alkyl group in a following [Table 4], respectively.

As for an anion, fluorohydrogenate prepared according to Experimental Example 3-1 described above was used to prepare a compound according to Comparative Example 2-3.

### Preparing of compound according to Comparative Example 2-4

As for a cation, thiazolidinium represented by the above <Chemical Formula 15> was provided. In this case, as shown in the following [Table 4], the R₁ and R₂are an alkyl group bonded to nitrogen respectively and two methyl groups were fixedly bonded to sulfur.

As for an anion, fluorohydrogenate prepared according to Experimental Example 3-1 described above was used to prepare a compound according to Comparative Example 2-4.

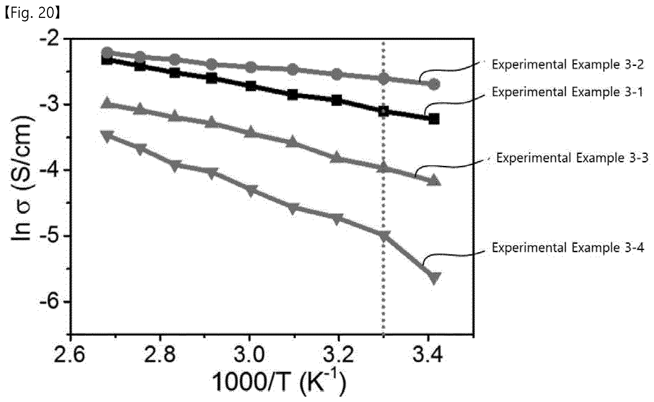

FIG. 20 is a graph showing a measured ion conductivity of a compound according to Experimental Examples 3-1 to 3-4 of the present invention.

Referring to FIG. 20, an ion conductivity of compounds according to Experimental Examples 3-1 to 3-4 was measured. As a result of measurement shown in FIG. 20, in case of having a methyl group according to Experimental Example 3-1, an ion conductivity was measured to be 4 mS/cm² at room temperature. In case of having an ethyl group according to Experimental Example 3-2, an ion conductivity was measured to be 74 mS/cm². In case of having a propyl group according to Experimental Example 3-3, an ion conductivity was measured to be 18.9 mS/cm². In case of having a butyl group according to Experimental Example 3-4, an ion conductivity was measured to be 6.8 mS/cm².

Compounds according to Experimental Examples 3-1 to 3-4 of the present invention were measured to have a high ion conductivity. In particular, in case of having an ethyl group according to Experimental Example 3-2, a compound was measured to have the highest ion conductivity.

An ion conductivity of compounds according to Comparative Examples 2-1 to 2-4 was measured at room temperature as shown in the following <Table 4>.

As can be understood from the following <Table 4>, it can be confirmed that a compound, in which fluorohydrogenate and thiazolium having an ethyl group according to Experimental Example 3-2 of the present invention are bonded, has a remarkably high ion conductivity compared with the compounds according to Comparative Examples 2-1 to 2-4.

**[Table 4]**

| | Cation | Alkyl group | Ion conductivity (mS/cm²) |
|---|---|---|---|
| Comparative Example 2-1 | Phospholanium | Methyl group/Ethyl group | 2 |
| | | Methyl group/Propyl group | 35 |
| | | Methyl group/Butyl group | 16 |
| | | Ethyl group/Butyl group | 45 |
| | | Methyl group/Methyl group | 24 |
| Comparative Example 2-2 | Imidazolium | Methyl group/Ethyl group | 14 |
| | | Methyl group/Propyl group | 6.5 |
| | | Methyl group/Butyl group | 8.9 |
| | | Ethyl group/Butyl group | 2.5 |
| Comparative Example 2-3 | Pyrrolidinium | Methyl group/Ethyl group | 7 |
| | | Methyl group/Propyl group | 65.3 |
| | | Methyl group/Butyl group | 14.5 |
| | | Ethyl group/Butyl group | 20 |
| | | Methyl group/Methyl group | 0.9 |
| Comparative Example 2-4 | Thiazolidinium | Methyl group/Ethyl group (N) + Two methyl groups (S) | 60 |
| | | Methyl group/Propyl group (N) + Two methyl groups (S) | 19.6 |
| | | Methyl group/Butyl group (N) + Two methyl groups (S) | 28.7 |
| | | Ethyl group/Butyl group (N) + Two methyl groups (S) | 5.8 |

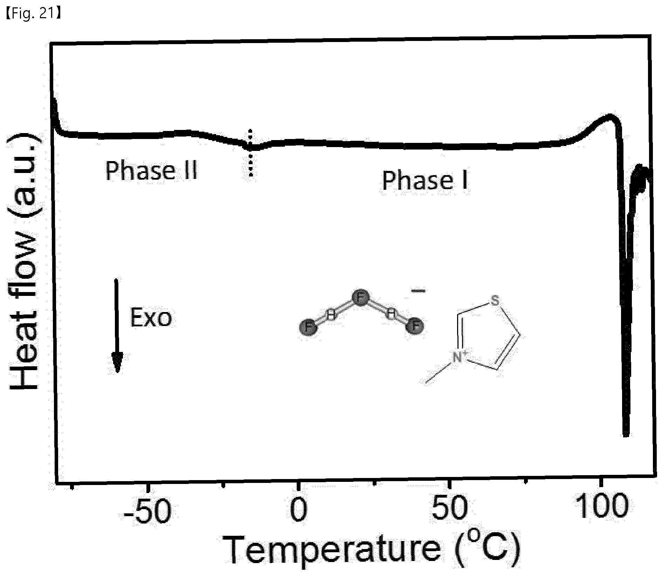

FIG. 21 is a differential scanning calorimetry (DSC) graph of a compound according to Experimental Example 3-1 of the present invention.

Referring to FIG. 21, a state change according to temperature is observed in the compound according to Experimental Example 3-1. Specifically, as shown in FIG. 3, it can be confirmed that the compound has a first crystal phase between -14°C and 110°C and a second crystal phase between -80°C and -14°C.

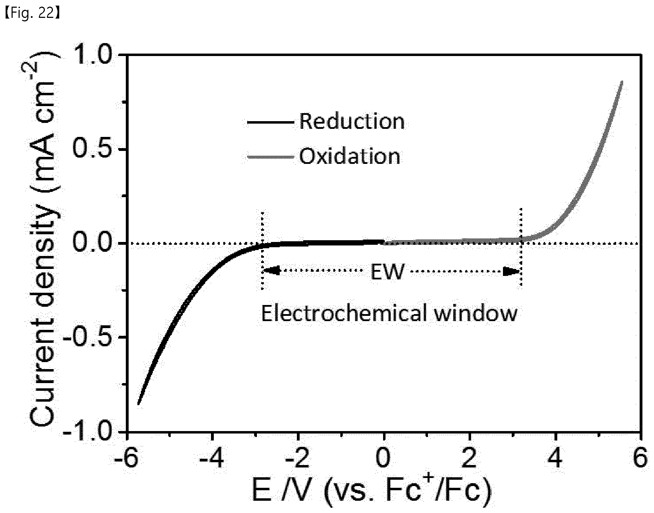

FIG. 22 is a graph showing a measured electrochemical window of a compound according to Experimental Example 3-1 of the present invention.

Referring to FIG. 22, it can be confirmed that the compound according to Experimental Example 3-1 has an electrochemical window up to -3V to +3V in a range of about 6V.

In other words, according to an embodiment of the present invention, it can be confirmed that a compound, in which cations including thiazolium and anions including fluorohydrogenate are prepared, maintains a solid state in a wide temperature range, while maintaining electrochemical stability and high ion conductivity.

### [Industrial Applicability]

According to an embodiment of the present invention, a solid electrolyte and a secondary battery including the same can be used in various fields of industry such as portable electronic devices, electric vehicles, ESS, etc.

## Claims

1. A solid electrolyte comprising a compound in which cations including one of thiophenium or thiazolium, and anions including fluorohydrogenate are bonded.

2. The solid electrolyte of claim 1, wherein the cation is thiophenium, the compound includes an alkyl group bonded with a sulfur element of the thiophenium, and the alkyl group includes one of a methyl group, an ethyl group, a propyl group or a butyl group.

3. The solid electrolyte of claim 2, wherein the cation is thiophenium, and the compound has an ion conductivity that decreases as a chain of the alkyl group becomes longer.

4. The solid electrolyte of claim 1, wherein the cation is thiophenium, and the compound includes a methyl group bonded with a sulfur element of the thiophenium, and has a first crystal phase in a temperature range of 28 to 90°C and a second crystal phase in a temperature range of 22 to 28°C in a heat flow spectrum according to temperature by differential scanning calorimetry (DSC).

5. The solid electrolyte of claim 1, wherein the cation is thiophenium and the solid electrolyte further comprises lithium salt, in which a unit cell of the compound has an orthorhombic crystal structure, the cation is provided at a vertex and at a center of a face of the crystal structure, the anion is provided in a middle of an edge of the crystal structure, and the lithium salt is arbitrarily provided at interstitial sites of the crystal structure, and
wherein an ion conductivity increases as a concentration of the lithium salt increases.

6. The solid electrolyte of claim 1, wherein the cation is thiophenium, a methyl group bonded with a sulfur element of the thiophenium is provided, and the solid electrolyte has a crystal phase in a temperature range of 28 to 70°C in a heat flow spectrum according to temperature by differential scanning calorimetry (DSC).

7. The solid electrolyte of claim 1, wherein the cation is thiazolium, the compound includes an alkyl group bonded with a nitrogen element of the thiazolium, and the alkyl group includes one of a methyl group, an ethyl group, a propyl group or a butyl group, and preferably the compound includes an ethyl group bonded with a nitrogen element of the thiazolium.

8. The solid electrolyte of claim 1, wherein the cation is thiazolium, and the solid electrolyte further comprises lithium salt.

9. A solid electrolyte comprising a compound in which cations and anions are bonded, wherein the compound has a crystal phase
wherein a molecular weight of the cation is 95 g/mol or more, a molecular weight of the anion is more than 60 g/mol, and a hydrogen ion concentration (pH) of the anion is less than 3, in which an entropy of fusion of the compound is 15-25 J/K mol.

10. The solid electrolyte of claim 9, wherein the cation comprises a pentagonal heterocyclic compound, in which the heterocyclic compound includes one element of sulfur, nitrogen, oxygen or phosphorus.

11. The solid electrolyte of claim 9, wherein, when the cation includes thiophenium, the anion includes one of fluorohydrogenate, cyano(nitroso)methanide or tetrazoline.

12. A method for preparing a solid electrolyte, the method comprising:
providing a mixed solution containing one of thiophenium salt or thiazolium salt, and a fluorohydrogenate precursor: and
reacting the mixed solution at a temperature lower than room temperature to prepare a compound in which thiophenium and fluorohydrogenate are bonded, or a compound in which thiazolium and fluorohydrogenate are bonded.

13. The method of claim 12, wherein the providing of the mixed solution comprises preparing the thiophenium salt or the thiazolium salt, in which the preparing of the thiophenium salt or the thiazolium salt includes:
providing an alkyl group precursor solution;
dripping thiophene or thiazoline into the alkyl group precursor solution to prepare a cation source solution; and
reacting the cation source solution to prepare the thiophenium salt or the thiazolium salt containing the alkyl group, in which the alkyl group includes one of a methyl group, an ethyl group, a propyl group or a butyl group, and
wherein the providing of the mixed solution comprises preparing the fluorohydrogenate precursor, in which the preparing of the fluorohydrogenate precursor includes stirring a solution containing hydrofluoric acid and water to prepare the fluorohydrogenate precursor.

14. A method for preparing a solid electrolyte, the method comprising:
providing lithium fluorohydrogenate; and
mixing and heat-treating the compound according to claim 13 and the lithium fluorohydrogenate to prepare a lithium-doped solid electrolyte,
wherein the providing of the lithium fluorohydrogenate includes:
adding lithium salt into hydrofluoric acid aqueous solution to prepare a source solution; and
reacting the source solution at a temperature lower than room temperature to prepare the lithium fluorohydrogenate.

## Patentansprüche

1. Festelektrolyt, umfassend eine Verbindung, in der Kationen, einschließlich einem aus Thiophenium und Thiazolium, und Anionen, einschließlich Fluorohydrogenat, gebunden sind.

2. Festelektrolyt nach Anspruch 1, wobei das Kation Thiophenium ist, die Verbindung eine Alkylgruppe beinhaltet, die mit einem Schwefelelement des Thiopheniums gebunden ist, und die Alkylgruppe eines aus einer Methylgruppe, einer Ethylgruppe, einer Propylgruppe oder einer Butylgruppe beinhaltet.

3. Festelektrolyt nach Anspruch 2, wobei das Kation Thiophenium ist und die Verbindung eine Ionenleitfähigkeit aufweist, die abnimmt, wenn eine Kette der Alkylgruppe länger wird.

4. Festelektrolyt nach Anspruch 1, wobei das Kation Thiophenium ist und die Verbindung eine Methylgruppe beinhaltet, die mit einem Schwefelelement des Thiopheniums gebunden ist, und eine erste Kristallphase in einem Temperaturbereich von 28 bis 90 °C und eine zweite Kristallphase in einem Temperaturbereich von 22 bis 28 °C in einem Wärmestromspektrum gemäß Temperatur durch dynamische Differenzkalorimetrie (DSC) aufweist.

5. Festelektrolyt nach Anspruch 1, wobei das Kation Thiophenium ist und der Festelektrolyt ferner Lithiumsalz umfasst, in dem eine Elementarzelle der Verbindung eine orthorhombische Kristallstruktur aufweist, das Kation an einem Scheitelpunkt und an einem Zentrum einer Fläche der Kristallstruktur bereitgestellt ist, und das Anion in einer Mitte einer Kante der Kristallstruktur bereitgestellt ist, und das Lithiumsalz an Zwischengitterplätzen der Kristallstruktur willkürlich bereitgestellt ist, und
wobei eine Ionenleitfähigkeit zunimmt, wenn eine Konzentration des Lithiumsalzes zunimmt.

6. Festelektrolyt nach Anspruch 1, wobei das Kation Thiophenium ist, eine Methylgruppe, die mit einem Schwefelelement des Thiopheniums gebunden ist, bereitgestellt ist, und der Festelektrolyt eine Kristallphase in einem Temperaturbereich von 28 bis 70 °C in einem Wärmestromspektrum gemäß Temperatur durch dynamische Differenzkalorimetrie (DSC) aufweist.

7. Festelektrolyt nach Anspruch 1, wobei das Kation Thiazolium ist, die Verbindung eine Alkylgruppe beinhaltet, die mit einem Stickstoffelement des Thiazoliums gebunden ist, und die Alkylgruppe eines aus einer Methylgruppe, einer Ethylgruppe, einer Propylgruppe oder einer Butylgruppe beinhaltet, und bevorzugt die Verbindung eine Ethylgruppe beinhaltet, die mit einem Stickstoffelement des Thiazoliums gebunden ist.

8. Festelektrolyt nach Anspruch 1, wobei das Kation Thiazolium ist und der Festelektrolyt ferner Lithiumsalz umfasst.

9. Festelektrolyt, umfassend eine Verbindung, in der Kationen und Anionen gebunden sind, wobei die Verbindung eine Kristallphase aufweist,
wobei ein Molekulargewicht des Kations 95 g/mol oder mehr beträgt, ein Molekulargewicht des Anions mehr als 60 g/mol beträgt und eine Wasserstoffionenkonzentration (pH) des Anions weniger als 3 beträgt, in der eine Schmelzentropie der Verbindung 15-25 J/(K · mol) beträgt.

10. Festelektrolyt nach Anspruch 9, wobei das Kation eine fünfeckige heterocyclische Verbindung umfasst, in der die heterocyclische Verbindung ein Element aus Schwefel, Stickstoff, Sauerstoff oder Phosphor beinhaltet.

11. Festelektrolyt nach Anspruch 9, wobei, wenn das Kation Thiophenium beinhaltet, das Antion eines aus Fluorohydrogenat, Cyano(nitroso)methanid oder Tetrazolin beinhaltet.

12. Verfahren zum Herstellen eines Festelektrolyten, wobei das Verfahren Folgendes umfasst:
Bereitstellen einer Mischlösung, die eines aus Thiopheniumsalz oder Thiazoliumsalz und einen Fluorohydrogenat-Vorläufer enthält, und
Reagieren der Mischlösung bei einer Temperatur, die niedriger als Raumtemperatur ist, um eine Verbindung, in der Thiophenium und Fluorohydrogenat gebunden sind, oder eine Verbindung, in der Thiazolium und Fluorohydrogenat gebunden sind, herzustellen.

13. Verfahren nach Anspruch 12, wobei das Bereitstellen der Mischlösung das Herstellen des Thiopheniumsalzes oder des Thiazoliumsalzes umfasst, wobei das Herstellen des Thiopheniumsalzes oder des Thiazoliumsalzes Folgendes beinhaltet:
Bereitstellen einer Alkalygruppenvorläuferlösung;
Tröpfeln des Thiophens oder Thiazolins in die Alkalkygruppenvorläuferlösung, um eine Kationenquelllösung herzustellen, und
Reagieren der Kationenquelllösung, um das Thiopheniumsalz oder das Thiazoliumsalz herzustellen, das die Alkylgruppe enthält, wobei die Alkylgruppe eines aus einer Methylgruppe, einer Ethylgruppe, einer Propylgruppe oder einer Butylgruppe beinhaltet, und
wobei das Bereitstellen der Mischlösung das Herstellen des Fluorohydrogenat-Vorläufers umfasst, wobei das Herstellen des Fluorohydrogenat-Vorläufers das Rühren einer Lösung beinhaltet, die Flusssäure und Wasser enthält, um den Fluorohydrogenat-Vorläufer herzustellen.

14. Verfahren zum Herstellen eines Festelektrolyten, wobei das Verfahren Folgendes umfasst:
Bereitstellen von Lithium-Fluorohydrogenat; und
Mischen und Wärmebehandeln der Verbindung nach Anspruch 13 und des Lithium-Fluorohydrogenats, um einen Lithium-dotierten Festelektrolyten herzustellen,
wobei das Bereitstellen des Lithium-Fluorohydrogenats Folgendes beinhaltet:
Hinzugeben von Lithiumsalz in wässrige Flusssäurelösung, um eine Quelllösung herzustellen, und
Reagieren der Quelllösung bei einer Temperatur, die niedriger als Raumtemperatur ist, um das Lithium-Fluorohydrogenat herzustellen.

## Revendications

1. Electrolyte solide comprenant un composé dans lequel sont liés des cations incluant l'un parmi un thiophénium ou un thiazolium, et des anions incluant un fluorohydrogénate.

2. Électrolyte solide selon la revendication 1, dans lequel le cation est un thiophénium, le composé inclut un groupe alkyle lié à un élément soufre du thiophénium, et le groupe alkyle inclut l'un parmi un groupe méthyle, un groupe éthyle, un groupe propyle ou un groupe butyle.

3. Électrolyte solide selon la revendication 2, dans lequel le cation est un thiophénium, et le composé a une conductivité ionique qui diminue au fur et à mesure qu'une chaîne du groupe alkyle s'allonge.

4. Électrolyte solide selon la revendication 1, dans lequel le cation est un thiophénium, et le composé inclut un groupe méthyle lié à un élément soufre du thiophénium, et a une première phase cristalline dans une plage de température de 28 à 90 °C et une deuxième phase cristalline dans une plage de température de 22 à 28 °C dans un spectre de flux de chaleur selon la température par calorimétrie à balayage différentiel (DSC).

5. Électrolyte solide selon la revendication 1, dans lequel le cation est un thiophénium et l'électrolyte solide comprend en outre un sel de lithium, dans lequel une cellule unitaire du composé a une structure cristalline orthorhombique, le cation est prévu à un sommet et en un centre d'une face de la structure cristalline, l'anion est prévu dans un milieu d'une arête de la structure cristalline, et le sel de lithium est prévu arbitrairement à des sites interstitiels de la structure cristalline, et
dans lequel la conductivité ionique augmente au fur et à mesure qu'une concentration du sel de lithium augmente.

6. Électrolyte solide selon la revendication 1, dans lequel le cation est un thiophénium, un groupe méthyle lié à un élément soufre du thiophénium est prévu, et l'électrolyte solide a une phase cristalline dans une plage de température de 28 à 70 °C dans un spectre de flux de chaleur selon la température par calorimétrie à balayage différentiel (DSC).

7. Électrolyte solide selon la revendication 1, dans lequel le cation est un thiazolium, le composé inclut un groupe alkyle lié à un élément azote du thiazolium, et le groupe alkyle inclut l'un parmi un groupe méthyle, un groupe éthyle, un groupe propyle ou un groupe butyle, et de préférence le composé inclut un groupe éthyle lié à un élément azote du thiazolium.

8. Électrolyte solide selon la revendication 1, dans lequel le cation est un thiazolium, et l'électrolyte solide comprend en outre un sel de lithium.

9. Électrolyte solide comprenant un composé dans lequel des cations et des anions sont liés, dans lequel le composé a une phase cristalline
dans lequel un poids moléculaire du cation est égal ou supérieur à 95 g/mol, un poids moléculaire de l'anion est supérieur à 60 g/mol, et une concentration en ions hydrogène (pH) de l'anion est inférieure à 3, dans lequel l'entropie de fusion du composé est de 15 à 25 J/K mol.

10. Électrolyte solide selon la revendication 9, dans lequel le cation comprend un composé hétérocyclique pentagonal, dans lequel le composé hétérocyclique inclut un élément soufre, azote, oxygène ou phosphore.

11. Électrolyte solide selon la revendication 9, dans lequel, lorsque le cation inclut un thiophénium, l'anion inclut l'un parmi un fluorohydrogénate, un cyano(nitroso)méthanide ou une tétrazoline.

12. Procédé de préparation d'un électrolyte solide, le procédé comprenant :
la fourniture d'une solution mixte contenant l'un parmi un sel de thiophénium ou un sel de thiazolium, et un précurseur de fluorohydrogénate ; et
la réaction de la solution mixte à une température inférieure à la température ambiante pour préparer un composé dans lequel un thiophénium et un fluorohydrogénate sont liés, ou un composé dans lequel un thiazolium et un fluorohydrogénate sont liés.

13. Procédé selon la revendication 12, dans lequel la fourniture de la solution mixte comprend la préparation du sel de thiophénium ou du sel de thiazolium, dans lequel la préparation du sel de thiophénium ou du sel de thiazolium inclut :
la fourniture d'une solution de précurseur de groupe alkyle ;
l'ajout au goutte-à-goutte de thiophène ou de thiazoline à la solution de précurseur de groupe alkyle pour préparer une solution source de cations ; et
la réaction de la solution source de cations pour préparer le sel de thiophénium ou le sel de thiazolium contenant le groupe alkyle, dans lequel le groupe alkyle inclut l'un parmi un groupe méthyle, un groupe éthyle, un groupe propyle ou un groupe butyle, et
dans lequel la fourniture de la solution mixte comprend la préparation du précurseur de fluorohydrogénate, dans lequel la préparation du précurseur de fluorohydrogénate inclut l'agitation d'une solution contenant de l'acide fluorhydrique et de l'eau pour préparer le précurseur de fluorohydrogénate.

14. Procédé de préparation d'un électrolyte solide, le procédé comprenant :
la fourniture de fluorohydrogénate de lithium ; et
le mélange et le traitement thermique du composé selon la revendication 13 et du fluorohydrogénate de lithium pour préparer un électrolyte solide dopé au lithium,
dans lequel la fourniture du fluorohydrogénate de lithium inclut :
l'ajout de sel de lithium à une solution aqueuse d'acide fluorhydrique pour préparer une solution source ; et
la réaction de la solution source à une température inférieure à la température ambiante pour préparer un fluorohydrogénate de lithium.
